# EUROPEAN PATENT APPLICATION

(11) **EP 4 661 602 A1**
(43) Date of publication of application: **10.12.2025**
(21) Application number: 24870043.7
(22) Date of filing: 23.07.2024
(51) Int. Cl.: H05K 1/02, H05K 3/28, H05K 3/22, H05K 1/18, H05K 7/20, H05K 9/00

(54) **COOLING AND SHIELDING STRUCTURE, PROCESSING METHOD, CIRCUIT BOARD ASSEMBLY, AND ELECTRONIC APPARATUS**

(30) Priority: 28.09.2023 CN 202311279857
(71) Applicant: Honor Device Co., Ltd., Shenzhen, Guangdong 518040 (CN)
(72) Inventor: GUO, Xueping, Shenzhen, Guangdong 518040 (CN); LIU, Zihao, Shenzhen, Guangdong 518040 (CN); DING, Caihua, Shenzhen, Guangdong 518040 (CN)
(74) Representative: Thun, Clemens
(86) International application number: PCT/CN2024/107002
(87) International publication number: WO 2025/066488

(57) **Abstract**

This application relates to heat dissipation structures, and in particular, to a heat dissipation shielding structure and a processing method, a circuit board assembly, and an electronic device. The heat dissipation shielding structure is used in a printed circuit board. The printed circuit board includes a mounting surface. Electronic components are mounted on the mounting surface. The electronic components include an active component and a passive component. The heat dissipation shielding structure includes an insulating layer. The insulating layer is covered on the mounting surface, wraps a side surface and a top surface of the passive component, and wraps at least a side surface of the active component, so that a side that is of the insulating layer and that faces away from the mounting surface forms a first surface or a side that is of the insulating layer and that faces away from the mounting surface forms a first surface together with a top surface of the active component. A shielding layer is covered on the first surface, a shape of the shielding layer matches a shape of the first surface, and the shielding layer is electrically connected to a ground network of the printed circuit board. The heat dissipation shielding structure provided in this application can implement a shielding effect on the electronic components on the printed circuit board and can further improve a heat dissipation effect on the electronic components, thereby improving operating stability and safety of the printed circuit board.

## Description

This application claims priority to Chinese Patent Application No. 202311279857.7, filed with the China National Intellectual Property Administration on September 28, 2023 and entitled "HEAT DISSIPATION SHIELDING STRUCTURE AND PROCESSING METHOD, CIRCUIT BOARD ASSEMBLY, AND ELECTRONIC DEVICE", which is incorporated herein by reference in its entirety.

### TECHNICAL FIELD

This application relates to heat dissipation structures, and in particular, to a heat dissipation shielding structure and a processing method, a circuit board assembly, and an electronic device.

### BACKGROUND

As functions of electronic devices are increased, there are increasingly more electronic components on a printed circuit board (Printed Circuit Board, PCB). Some electronic components on the printed circuit board need to be shielded to avoid interference between the electronic components and prevent a user from being affected. Therefore, a shielding cover usually needs to be covered on the printed circuit board to implement shielding.

However, because the electronic components generate heat during operating and the heat is accumulated inside the shielding cover, a heat dissipation effect on the electronic components is poor, even affecting service lives of the electronic components and the printed circuit board.

### SUMMARY

To resolve the foregoing problem, this application provides a heat dissipation shielding structure and a processing method, a circuit board assembly, and an electronic device, to implement a shielding effect on electronic components on a printed circuit board and further improve a heat dissipation effect on the electronic components, thereby improving operating stability and safety of the printed circuit board.

To achieve the foregoing objective, according to a first aspect, this application provides a heat dissipation shielding structure, used in a printed circuit board. The printed circuit board includes a mounting surface. Electronic components are mounted on the mounting surface. The electronic components include an active component and a passive component. Heat generation of the active component is greater than heat generation of the passive component. The heat dissipation shielding structure includes: an insulating layer, where the insulating layer is covered on the mounting surface, wraps a side surface and a top surface of the passive component, and wraps at least a side surface of the active component, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components; and a shielding layer, where the shielding layer is covered on the first surface, a shape of the shielding layer matches a shape of the first surface, and the shielding layer is electrically connected to a ground network of the printed circuit board.

In this implementation provided in this application, the insulating layer and the shielding layer that undulatingly change with the different heights of the electronic components are disposed on the printed circuit board, so that distances between the top surfaces of the electronic components and the shielding layer are similar to each other. In this way, heat of the electronic components can be transferred to the shielding layer as soon as possible, thereby improving a heat dissipation effect. In addition, because a thermal conductivity of the insulating layer is greater than a thermal conductivity of air, the insulating layer is disposed between the shielding layer and the electronic components, to implement insulative isolation for the electronic components, and improve heat conduction efficiency between the electronic components and the shielding layer, thereby improving the heat dissipation effect.

In an implementation, the insulating layer wraps the side surface of the active component, so that the side that is of the insulating layer and that faces away from the mounting surface forms the first surface together with the top surface of the active component; and the shielding layer is covered on the top surface of the active component. In this way, the shielding layer may directly contact the top surface of the active component, to improve a heat dissipation effect on the active component.

In an implementation, the insulating layer wraps the side surface and the top surface of the active component, so that the side that is of the insulating layer and that faces away from the mounting surface forms the first surface; a first trench is disposed on the insulating layer, and the first trench is located between the top surface of the active component and the shielding layer, and enables the top surface of the active component to be in communication with the shielding layer; and a thermal conductive structure is filled in the first trench, one end of the thermal conductive structure is connected to the top surface of the active component, and the other end of the thermal conductive structure is connected to the shielding layer. In this way, the top surface of the active component can be connected to the shielding layer by using the thermal conductive structure, to improve heat conduction efficiency of the active component, thereby improving a heat dissipation effect on the active component.

In an implementation, the heat dissipation shielding layer further includes a graphite layer, where the graphite layer is covered on a side that is of the shielding layer and that faces away from the first surface. In this way, the graphite layer may be used to perform thermal spreading on heat of the shielding layer, to avoid a local high temperature. In addition, the graphite layer is disposed to further increase a heat exchange area with air, thereby improving the heat dissipation effect.

In an implementation, a thermal conductive gel is disposed between the shielding layer and the graphite layer. In this way, the thermal conductive gel may be used to fill a slit between the shielding layer and the graphite layer, thereby improving the heat dissipation effect.

In an implementation, the shielding layer has a concave portion; the concave portion is close to an edge of the electronic component and is recessed toward the insulating layer; and the thermal conductive gel is filled in at least the concave portion. In this way, the thermal conductive gel may be filled in the concave portion to prevent an air gap from occurring because the graphite layer cannot fill the concave portion, thereby improving heat conduction efficiency and improving the heat dissipation effect.

In an implementation, a ground pad is mounted on the mounting surface; and the shielding layer is electrically connected to the ground pad. In this way, space occupied by a ground structure of the shielding layer can be narrowed while the shielding layer is grounded.

In an implementation, a second trench is disposed on the insulating layer, and the second trench is located between a top surface of the ground pad and the shielding layer, and enables the top surface of the ground pad to be in communication with the shielding layer; the shielding layer includes a main body portion and a first electrical conductive portion; the main body portion is covered on the first surface, and a shape of the main body portion matches the shape of the first surface; and the first electrical conductive portion is filled in the second trench, one end of the first electrical conductive portion is connected to the main body portion, and the other end of the first electrical conductive portion is connected to the top surface of the ground pad. In this way, the shielding layer may be directly connected to the ground pad through the second trench, so that the shielding layer is grounded.

In an implementation, a second trench is disposed on the insulating layer, and the second trench is located between a top surface of the ground pad and the shielding layer, and enables the top surface of the ground pad to be in communication with the shielding layer; and a first electrical conductive structure is filled in the second trench, and the first electrical conductive structure is electrically connected to the ground pad and the shielding layer. In this way, the shielding layer can be electrically connected to the ground pad by using the first electrical conductive structure.

In an implementation, one end of the first electrical conductive structure is connected to the top surface of the ground pad, and the other end of the first electrical conductive structure is connected to the shielding layer. In this way, the shielding layer can be electrically connected to the ground pad by using the first electrical conductive structure.

In an implementation, the heat dissipation shielding structure further includes an electrical conductive cushion block, and the electrical conductive cushion block is disposed on the top surface of the ground pad; the insulating layer wraps a side surface and a top surface of the electrical conductive cushion block; the second trench is located between the top surface of the electrical conductive cushion block and the shielding layer, and enables the top surface of the electrical conductive cushion block to be in communication with the shielding layer; and one end of the first electrical conductive structure is connected to the top surface of the electrical conductive cushion block, and the other end of the first electrical conductive structure is connected to the shielding layer. In this way, a distance between the shielding layer and the ground pad can be shortened by using the electrical conductive cushion block, to prevent the second trench from being excessively deep, thereby facilitating filling of the first electrical conductive structure and grounding the shielding layer.

In an implementation, the heat dissipation shielding structure further includes an electrical conductive cushion block, and the electrical conductive cushion block is disposed on the top surface of the ground pad; the insulating layer wraps a side surface of the electrical conductive cushion block; a top surface of the electrical conductive cushion block is located on the first surface; and the shielding layer is connected to the electrical conductive cushion block. In this way, the shielding layer can be electrically connected to the ground pad by using the electrical conductive cushion block.

In an implementation, the passive component includes a capacitor, and the capacitor has a ground terminal; and the shielding layer is electrically connected to the ground terminal. In this way, the shielding layer can be grounded by using the capacitor without additionally disposing a ground structure, thereby facilitating miniaturization design of the printed circuit board.

In an implementation, a third trench is disposed on the insulating layer, and the third trench is located between a top surface of the ground terminal and the shielding layer, and enables the top surface of the ground terminal to be in communication with the shielding layer; the shielding layer includes a main body portion and a second electrical conductive portion; the main body portion is covered on the first surface, and a shape of the main body portion matches the shape of the first surface; and the second electrical conductive portion is filled in the third trench, one end of the second electrical conductive portion is connected to the main body portion, and the other end of the second electrical conductive portion is connected to the top surface of the ground terminal. In this way, the shielding layer can be directly connected to the ground terminal, so that the shielding layer is grounded.

In an implementation, a third trench is disposed on the insulating layer, and the third trench is located between a top surface of the ground terminal and the shielding layer, and enables the top surface of the ground terminal to be in communication with the shielding layer; and a second electrical conductive structure is filled in the third trench, one end of the second electrical conductive structure is connected to the top surface of the ground terminal, and the other end of the second electrical conductive structure is connected to the shielding layer. In this way, the shielding layer can be electrically connected to the ground terminal by using the second electrical conductive structure.

In an implementation, the electronic component is connected to the mounting surface by using an electrical connection structure, and there is a gap between a bottom surface of the electronic component and the mounting surface; and the heat dissipation shielding structure further includes a protective structure, the protective structure is filled in the gap between the bottom surface of the electronic component and the mounting surface and surrounds the electrical connection structure, and a material of the protective structure is an insulating material. In this way, connection between the electronic component and the mounting surface can be protected by using the protective structure.

In an implementation, the active component includes a processor and a memory that are stacked; the processor is connected to the mounting surface; and the memory is electrically connected to the processor. In this way, functions of the printed circuit board can be implemented.

According to a second aspect, this application provides a processing method of a heat dissipation shielding structure, including: providing a printed circuit board, where the printed circuit board includes a mounting surface, electronic components are mounted on the mounting surface, the electronic components include an active component and a passive component, and heat generation of the active component is greater than heat generation of the passive component; covering an insulating material on the mounting surface, and wrapping a side surface and a top surface of the passive component and wrapping at least a side surface of the active component with the insulating material, to form an insulating layer, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components; and covering a shielding material on the first surface to form a shielding layer, so that a shape of the shielding layer matches a shape of the first surface, and the shielding layer is electrically connected to a ground network of the printed circuit board. The insulating layer and the shielding layer that undulatingly change with the different heights of the electronic components are disposed on the printed circuit board, so that distances between the top surfaces of the electronic components and the shielding layer are similar to each other. In this way, heat of the electronic components can be transferred to the shielding layer as soon as possible, thereby improving a heat dissipation effect. In addition, because a thermal conductivity of the insulating layer is greater than a thermal conductivity of air, the insulating layer is disposed between the shielding layer and the electronic components, to implement insulative isolation for the electronic components, and improve heat conduction efficiency between the electronic components and the shielding layer, thereby improving the heat dissipation effect.

In an implementation, the covering an insulating material on the mounting surface, and wrapping a side surface and a top surface of the passive component and wrapping at least a side surface of the active component with the insulating material, to form an insulating layer, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components includes: covering the insulating material on the mounting surface, and wrapping the side surface and the top surface of each of the active component and the passive component with the insulating material; removing the insulating material from the top surface of the active component to expose the top surface of the active component to form the insulating layer, so that the side that is of the insulating layer and that faces away from the mounting surface forms the first surface together with the top surface of the active component, and the first surface undulatingly changes with the different heights of the electronic components. In this way, the shielding layer subsequently directly contacts the top surface of the active component, to improve a heat dissipation effect on the active component.

In an implementation, the insulating material wraps the side surface and the top surface of the active component; and after the covering an insulating material on the mounting surface, and wrapping a side surface and a top surface of the passive component and wrapping at least a side surface of the active component with the insulating material, to form an insulating layer, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components, the method further includes: removing a part of the insulating material from the top surface of the active component to form a first trench on the insulating layer, so that the first trench is in communication with the top surface of the active component to expose the top surface of the active component. In this way, a position for filling a thermal conductive structure may be provided, so that the top surface of the active component can be connected to the shielding layer by using the thermal conductive structure, to improve heat conduction efficiency of the active component, thereby improving a heat dissipation effect on the active component.

In an implementation, after the removing a part of the insulating material from the top surface of the active component to form a first trench on the insulating layer, so that the first trench is in communication with the top surface of the active component, the method further includes: filling a thermal conductive material in the first trench to form a thermal conductive structure, so that the thermal conductive structure is connected to the top surface of the active component, and a side surface that is of the thermal conductive structure and that faces away from the active component is located on the first surface. In this way, the top surface of the active component can be connected to the shielding layer by using the thermal conductive structure, to improve heat conduction efficiency of the active component, thereby improving a heat dissipation effect on the active component.

In an implementation, after the covering a shielding material on the first surface to form a shielding layer, so that a shape of the shielding layer matches a shape of the first surface, and the shielding layer is electrically connected to a ground network of the printed circuit board, the method further includes: covering graphite on a side that is of the shielding layer and that faces away from the first surface, to form a graphite layer. In this way, the graphite layer may be used to perform thermal spreading on heat of the shielding layer, to avoid a local high temperature. In addition, the graphite layer is disposed to further increase a heat exchange area with air, thereby improving the heat dissipation effect.

In an implementation, before the covering graphite on a side that is of the shielding layer and that faces away from the first surface, to form a graphite layer, the method further includes: filling a thermal conductive gel in a liquid state in at least a partial position on the side that is of the shielding layer and that faces away from the first surface; and curing the thermal conductive gel. In this way, the thermal conductive gel may be used to fill a slit between the shielding layer and the graphite layer, thereby improving the heat dissipation effect.

In an implementation, a ground pad is mounted on the mounting surface; and before the covering a shielding material on the first surface to form a shielding layer, so that a shape of the shielding layer matches a shape of the first surface, and the shielding layer is electrically connected to a ground network of the printed circuit board, the method further includes: removing a part of the insulating material from a top surface of the ground pad to form a second trench on the insulating layer, so that the second trench is in communication with the top surface of the ground pad to expose the top surface of the ground pad. In this way, the shielding layer can be subsequently electrically connected to the ground pad.

In an implementation, after the removing a part of the insulating material from a top surface of the ground pad to form a second trench on the insulating layer, so that the second trench is in communication with the top surface of the ground pad to expose the top surface of the ground pad, the method further includes: filling an electrical conductive material in the second trench to form a first electrical conductive structure, so that one end of the first electrical conductive structure is connected to the top surface of the ground pad and the other end of the first electrical conductive structure is located on the first surface. In this way, the shielding layer can be electrically connected to the ground pad by using the first electrical conductive structure.

In an implementation, a ground pad is mounted on the mounting surface; and after the providing a printed circuit board, where the printed circuit board includes a mounting surface, electronic components are mounted on the mounting surface, the electronic components include an active component and a passive component, and heat generation of the active component is greater than heat generation of the passive component, the method further includes: disposing an electrical conductive cushion block on the ground pad. In this way, the shielding layer can be electrically connected to the ground pad by using the electrical conductive cushion block.

In an implementation, before the covering a shielding material on the first surface to form a shielding layer, so that a shape of the shielding layer matches a shape of the first surface, and the shielding layer is electrically connected to a ground network of the printed circuit board, the method further includes: removing the insulating material from a top surface of the electrical conductive cushion block to expose the top surface of the electrical conductive cushion block, and the top surface of the electrical conductive cushion block is located on the first surface. In this way, the electrical conductive cushion block can be subsequently electrically connected to the shielding layer.

In an implementation, before the covering a shielding material on the first surface to form a shielding layer, so that a shape of the shielding layer matches a shape of the first surface, and the shielding layer is electrically connected to a ground network of the printed circuit board, the method further includes: removing a part of the insulating material from a top surface of the electrical conductive cushion block to form a second trench on the insulating layer, so that the second trench is in communication with the top surface of the electrical conductive cushion block to expose the top surface of the electrical conductive cushion block. In this way, the electrical conductive cushion block can be subsequently electrically connected to the shielding layer.

In an implementation, after the removing a part of the insulating material from a top surface of the electrical conductive cushion block to form a second trench on the insulating layer, so that the second trench is in communication with the top surface of the electrical conductive cushion block to expose the top surface of the electrical conductive cushion block, the method further includes: filling an electrical conductive material in the second trench to form a first electrical conductive structure, so that one end of the first electrical conductive structure is connected to the top surface of the electrical conductive cushion block, and the other end of the first electrical conductive structure is located on the first surface. In this way, a distance between the shielding layer and the ground pad can be shortened by using the electrical conductive cushion block, to prevent the second trench from being excessively deep, thereby facilitating filling of the first electrical conductive structure and grounding the shielding layer.

In an implementation, the passive component includes a capacitor, and the capacitor has a ground terminal; and before the covering a shielding material on the first surface to form a shielding layer, so that a shape of the shielding layer matches a shape of the first surface, and the shielding layer is electrically connected to a ground network of the printed circuit board, the method further includes: removing the insulating material from a top surface of the ground terminal to expose the top surface of the ground terminal, so that the top surface of the ground terminal is located on the first surface. In this way, the shielding layer can be grounded by using the capacitor without additionally disposing a ground structure, thereby facilitating miniaturization design of the printed circuit board.

In an implementation, the passive component includes a capacitor, and the capacitor has a ground terminal; and before the covering a shielding material on the first surface to form a shielding layer, so that a shape of the shielding layer matches a shape of the first surface, and the shielding layer is electrically connected to a ground network of the printed circuit board, the method further includes: removing a part of the insulating material from a top surface of the ground terminal to form a third trench on the insulating layer, so that the third trench is in communication with the top surface of the ground terminal to expose the top surface of the ground terminal. In this way, the shielding layer can be electrically connected to the ground terminal.

In an implementation, after the removing a part of the insulating material from a top surface of the ground terminal to form a third trench on the insulating layer, so that the third trench is in communication with the top surface of the ground terminal to expose the top surface of the ground terminal, the method further includes: filling an electrical conductive material in the third trench to form a second electrical conductive structure, so that one end of the second electrical conductive structure is connected to the top surface of the ground terminal and the other end of the second electrical conductive structure is located on the first surface. In this way, the shielding layer can be electrically connected to the ground terminal by using the second electrical conductive structure.

In an implementation, after the providing a printed circuit board, where the printed circuit board includes a mounting surface, electronic components are mounted on the mounting surface, the electronic components include an active component and a passive component, and heat generation of the active component is greater than heat generation of the passive component, the method further includes: filling a protective adhesive in a gap between a bottom surface of the electronic component and the mounting surface, so that the protective adhesive surrounds an electrical connection structure connecting the bottom surface of the electronic component and the mounting surface, where a material of the protective adhesive is an insulating material; and curing the protective adhesive to form a protective structure. In this way, connection between the electronic component and the mounting surface can be protected by using the protective structure.

According to a third aspect, this application provides a circuit board assembly, including a printed circuit board and the heat dissipation shielding structure according to the first aspect. The printed circuit board includes a mounting surface. Electronic components are mounted on the mounting surface. The electronic components include an active component and a passive component. Heat generation of the active component is greater than heat generation of the passive component. An insulating layer is covered on the mounting surface, the insulating layer wraps a side surface and a top surface of the passive component, and the insulating layer wraps at least a side surface of the active component. A shielding layer is electrically connected to a ground network of the printed circuit board.

According to a fourth aspect, this application provides an electronic device, including the circuit board assembly according to the third aspect.

### BRIEF DESCRIPTION OF DRAWINGS

To describe technical solutions of this application more clearly, the following briefly describes accompanying drawings required in embodiments. Apparently, a person of ordinary skill in the art may still derive other accompanying drawings from these accompanying drawings without creative efforts.
FIG. 1 shows a circuit board module with a shielding cover according to an embodiment;
FIG. 2 shows another circuit board module with a shielding cover according to an embodiment;
FIG. 3 is a schematic diagram of a first structure of a heat dissipation shielding structure and a printed circuit board according to an embodiment;
FIG. 4 is a schematic exploded view of FIG. 3;
FIG. 5 is a schematic diagram of a structure of an active component according to an embodiment;
FIG. 6 is a schematic diagram of a second structure of a heat dissipation shielding structure and a printed circuit board according to an embodiment;
FIG. 7 is a schematic exploded view of FIG. 6;
FIG. 8 is a schematic diagram of a third structure of a heat dissipation shielding structure and a printed circuit board according to an embodiment;
FIG. 9 is a schematic exploded view of FIG. 8;
FIG. 10 is a schematic diagram of a fourth structure of a heat dissipation shielding structure and a printed circuit board according to an embodiment;
FIG. 11 is an exploded view of FIG. 10;
FIG. 12 is a schematic diagram of a fifth structure of a heat dissipation shielding structure and a printed circuit board according to an embodiment;
FIG. 13 is an exploded view of FIG. 12;
FIG. 14 is a flowchart of a first processing method of a heat dissipation shielding structure according to an embodiment;
FIG. 15 is a diagram of a first procedure of processing a heat dissipation shielding structure on a printed circuit board according to an embodiment;
FIG. 16 is a flowchart of a second processing method of a heat dissipation shielding structure according to an embodiment;
FIG. 17 shows a first partial procedure of a diagram of a second procedure of processing a heat dissipation shielding structure on a printed circuit board according to an embodiment;
FIG. 18 shows a second partial procedure of a diagram of a second procedure of processing a heat dissipation shielding structure on a printed circuit board according to an embodiment;
FIG. 19 is a flowchart of a third processing method of a heat dissipation shielding structure according to an embodiment;
FIG. 20 shows a first partial procedure of a diagram of a third procedure of processing a heat dissipation shielding structure on a printed circuit board according to an embodiment;
FIG. 21 shows a second partial procedure of a diagram of a third procedure of processing a heat dissipation shielding structure on a printed circuit board according to an embodiment; and
FIG. 22 shows a partial procedure of a diagram of a fourth procedure of processing a heat dissipation shielding structure on a printed circuit board according to an embodiment.

### DESCRIPTION OF EMBODIMENTS

The following clearly describes the technical solutions in the embodiments of this application with reference to the accompanying drawings in the embodiments of this application. It is clear that the described embodiments are some but not all of the embodiments of this application. Other embodiments obtained by a person of ordinary skill in the art based on the embodiments of this application without creative efforts shall fall within the protection scope of this application.

The terms "first" and "second" below are merely intended for a purpose of description, and shall not be understood as an indication or implication of relative importance or implicit indication of the quantity of indicated technical features. Therefore, a feature defined by "first", "second", and the like may explicitly or implicitly include one or more such features. In the descriptions of this application, unless otherwise stated, "a plurality of" means two or more.

In addition, in this application, positional terms such as "upper", "lower", "inner", and "outer" are defined relative to an illustrative position of a component in the accompanying drawings. It should be understood that these directional terms are relative concepts and are used for relative description and clarification, and may vary accordingly depending on the change of position where a component is placed in the accompanying drawings.

As a main component in an electronic device, a printed circuit board may implement functions such as circuit connection, signal transmission, power supply, control, and driving in the electronic device. The printed circuit board can implement the foregoing functions by using various electronic components disposed on the printed circuit board. As functions of electronic devices are increasingly enriched, types and a quantity of electronic components on a printed circuit board are also gradually increased.

Some electronic components emit electromagnetic waves of various frequency bands and intensities during operating of the printed circuit board. These electromagnetic waves may cause the electronic components to affect each other, resulting in electromagnetic interference and radio frequency interference. Consequently, normal functions of the electronic components are affected. These electromagnetic waves may further affect an external electronic device and a user.

In view of this, strict electromagnetic compatibility control requirements are imposed on the factory shipment of various electronic devices internationally.

To shield electromagnetic interference and radio frequency interference, a shielding cover may be disposed on the printed circuit board. The shielding cover may be one layer of metal covering made of copper or another electrical conductive material. The shielding cover is covered on electronic components requiring shielding, a circuit, an assembly, and an entire printed circuit board, so that the electronic components on the printed circuit board and signals can be shielded and isolated. In this way, the electronic components can be prevented from being interfered by an external electromagnetic wave, or an electromagnetic wave generated by the electronic component inside the shielding cover can be prevented from affecting another component.

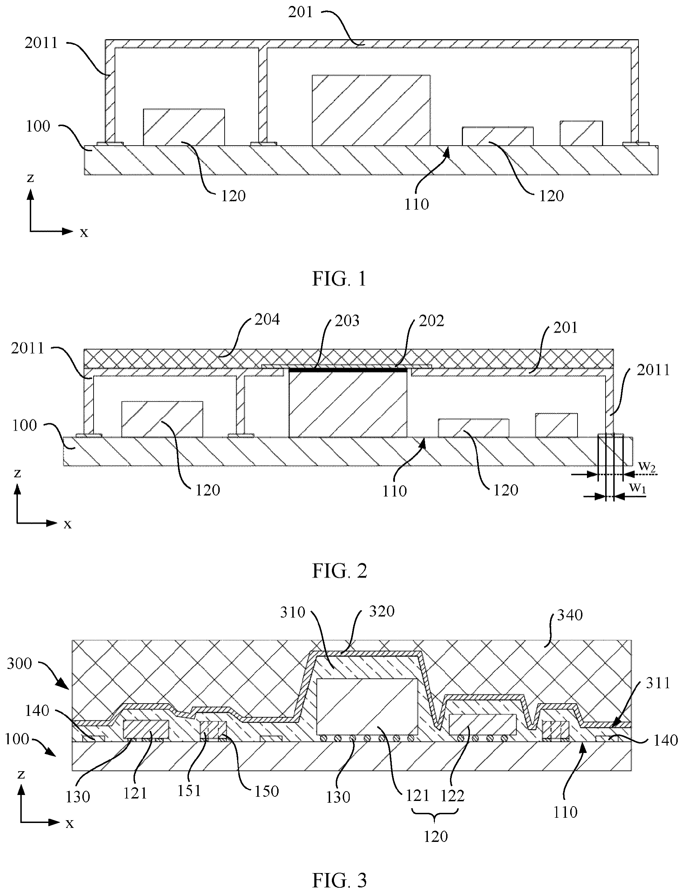

FIG. 1 shows a circuit board module with a shielding cover according to an embodiment.

As shown in FIG. 1, the circuit board module includes a printed circuit board 100 and a shielding cover 201.

The printed circuit board 100 includes a mounting surface 110, and a plurality of electronic components 120 are disposed on the mounting surface 110.

The shielding cover 201 is covered on the electronic components 120, and is grounded. The shielding cover 201 may be electrically connected to a ground network of the printed circuit board 100 by using a connection pillar 2011, or may be electrically connected to a ground network of an electronic device. Disposing the shielding cover 201 on the printed circuit board 100 can help improve an anti-interference capability and signal integrity and stability of the printed circuit board 100.

The electronic components 120 on the printed circuit board 100 generate heat when the printed circuit board 100 operates. The heat generated by the electronic components 120 can be dissipated into air when the shielding cover 201 is not disposed, thereby reducing impact of a high temperature on performance of the electronic components 120.

However, the shielding cover 201 affects heat dissipation of the electronic components 120 therein after the shielding cover 201 is disposed on the printed circuit board 100. Main reasons are as follows.

Limited air flow: The shielding cover 201 is usually of a closed structure, which limits free flow of air in the cover. In a normal case, air flow can carry away the heat generated by the electronic components 120 to keep temperatures of the electronic components 120 stable. Existence of the shielding cover 201 hinders air flow. In this case, the heat cannot be effectively dissipated.

Heat accumulation: The shielding cover 201 limits a heat dissipation path, and therefore the heat in the cover is more easily accumulated. In the absence of enough heat dissipation measures such as a heat sink and a heat dissipation fan, the heat in the cover is gradually accumulated, resulting in temperature rising of the electronic components 120.

It can be learned that disposing the shielding cover 201 affects heat dissipation of the electronic components 120 therein.

In addition, as powers of the electronic components 120 gradually increase and sizes gradually decrease, heat generation of the electronic components 120 during operating is large, resulting in a rapid instantaneous temperature rise. A high temperature has harmful impact on performance of the electronic components 120 and even causes a fault. In this case, a heat dissipation structure may be disposed on surfaces of the electronic components 120, to perform heat dissipation on the electronic components 120.

However, because a structure of the printed circuit board 100 is small, a structure of the shielding cover 201 is small, and space inside the shielding cover 201 is limited, and is not enough to dispose the heat dissipation structure in the shielding cover 201. Consequently, heat dissipation is difficult to implement, and the electronic components 120 are prone to an over-temperature fault.

For example, to improve a heat dissipation effect on the electronic components 120 in the shielding cover 201, a height of the shielding cover 201 may be reduced, so that a higher electronic component 120 can directly contact the shielding cover 201. Because a heat conduction effect of the shielding cover 201 is superior to that of air, after the higher electronic component 120 contacts the shielding cover 201, the electronic component 120 can directly contact the shielding cover 201 for heat dissipation, thereby improving heat dissipation performance.

FIG. 2 shows another circuit board module with a shielding cover according to an embodiment.

As shown in FIG. 2, further, to improve the heat dissipation effect, the circuit board module may further include a copper foil 202, a thermal conductive adhesive 203, and graphite 204.

An opening is disposed at a position that is of the shielding cover 201 and that corresponds to the higher electronic component 120, and the copper foil 202 is covered on the opening. The copper foil 202 is used to close the opening to ensure a shielding effect.

The thermal conductive adhesive 203 is disposed between the copper foil 202 and a surface of the higher electronic component 120, to transfer heat of the electronic component 120 to the copper foil 202 by using the thermal conductive adhesive 203, thereby improving heat conduction efficiency.

The graphite 204 is covered on sides that are of the copper foil 202 and the shielding cover 201 and that face away from the printed circuit board 100 to transfer the heat on the copper foil 202 to the graphite 204, thereby increasing a heat exchange area with air and improving the heat dissipation effect.

However, the electronic components 120 on the printed circuit board 100 are usually different in height, and this problem also exists in the electronic components 120 in the shielding cover 201. The shielding cover 201 is usually a regular-shaped cover, and a side surface that is of the shielding cover 201 and that is opposite to a surface of the printed circuit board 100 is parallel to the mounting surface 110 of the printed circuit board 100. In this case, the height of the shielding cover 201 is fixed. Consequently, only a highest electronic component 120 can directly contact the shielding cover 201. A shorter electronic component 120 inside the shielding cover 201 is still surrounded by air inside the shielding cover 201, resulting in a poor heat dissipation effect on the shorter electronic component 120.

In conclusion, to implement shielding protection on the electronic components 120 and the heat dissipation effect on the electronic components 120 with different heights inside the shielding cover 201, this application provides a heat dissipation shielding structure 300 and a processing method thereof, a circuit board assembly, and an electronic device. The heat dissipation shielding structure 300 can improve the heat dissipation effect on the electronic components 120 with different heights on the printed circuit board 100, prolong service lives of the electronic components 120, and improve operating stability of the printed circuit board 100.

FIG. 3 is a schematic diagram of a first structure of a heat dissipation shielding structure and a printed circuit board according to an embodiment.

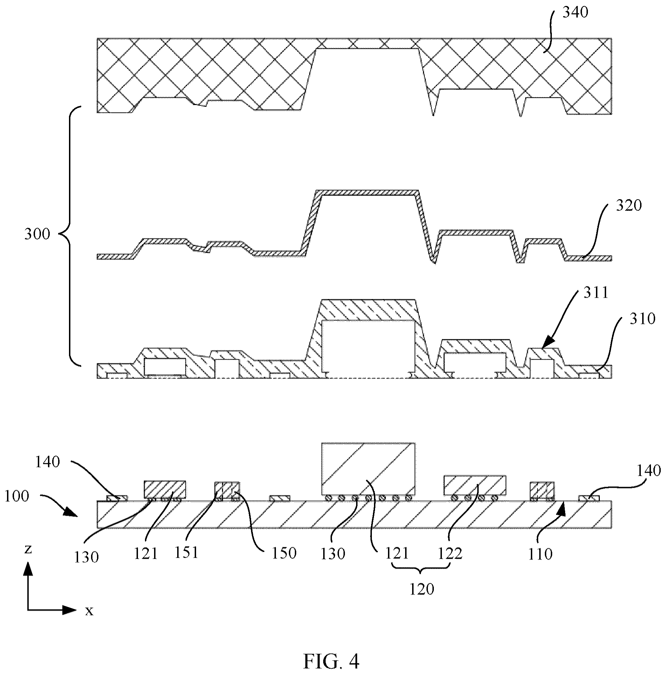

FIG. 4 is a schematic exploded view of FIG. 3.

As shown in FIG. 3 and FIG. 4, a printed circuit board 100 includes a mounting surface 110. Various electronic components 120 are mounted on the mounting surface 110 to implement function requirements of the printed circuit board 100 by using the electronic components 120.

The electronic components 120 may be mounted on the mounting surface 110 through a surface mount technology (Surface Mount Technology, SMT), to implement mounting and connection between the electronic components 120 and the printed circuit board 100.

For example, a solder ball or a solder post may be placed at a specified position on the mounting surface 110, the solder ball or the solder post is heated and melted, and then the electronic component 120 is connected to the melted solder ball or solder post. After cooling, the solder ball or the solder post forms an electrical connection structure 130 between the electronic component 120 and the printed circuit board 100. The electrical connection structure 130 can implement fastening of the electronic component 120 and electrical connection between the electronic component 120 and the printed circuit board 100.

It should be noted that, in another implementation, the electronic components 120 may alternatively be inserted into the printed circuit board 100. Connection and fastening between the electronic components 120 and the printed circuit board 100 are not limited in this embodiment.

The electronic components 120 include an active component 121 and a passive component 122.

The active component 121 is an electronic component that can actively input and output electrical energy or a signal, and can amplify, control, and adjust a current and a voltage by using a specific semiconductor material and a specific design structure. The active component 121 may include a nor flash (nor flash), a system-on-chip (System-on-Chip, SoC), a codec integrated circuit (codec IC), a charger (charger), a Bluetooth chip, a radio frequency chip, a wireless fidelity (Wireless Fidelity, WiFi) chip, a near field communication (Near Field Communication, NFC) chip, a power management unit (Power Management Unit, PMU), or the like.

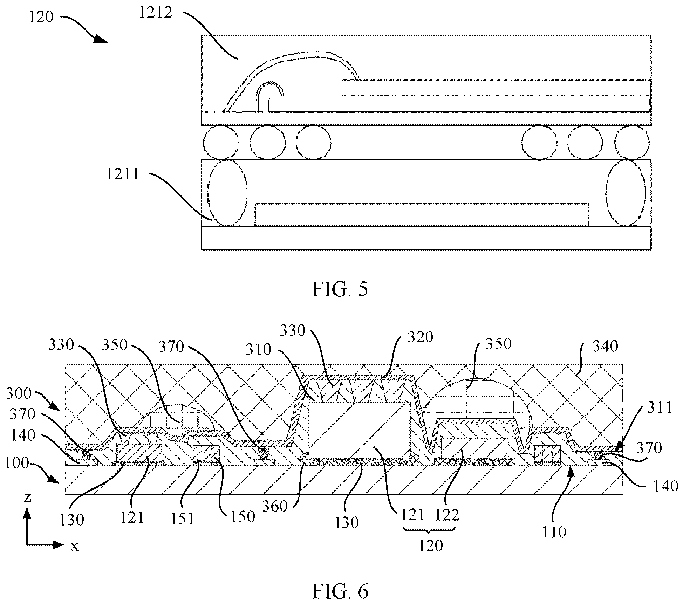

FIG. 5 is a schematic diagram of a structure of an active component according to an embodiment.

As shown in FIG. 5, for example, the active component 121 disposed on the printed circuit board 100 includes a SoC. The active component 121 may include a processor 1211 and a memory 1212 that are sequentially stacked.

The processor 1211 is connected to the printed circuit board 100, and the processor 1211 serves as a main computing engine, and can execute instructions and process various tasks.

The memory 1212 is electrically connected to the processor 1211, to store program code, data, and temporary variables. The memory 1212 may include a random access memory 1212 (Random Access Memory, RAM) and a read-only memory 1212 (Read-Only Memory, ROM).

The active component 121 may further include an external interface, for example, a universal serial bus (Universal Serial Bus, USB), an Ethernet, or wireless communication (for example, Bluetooth or WiFi).

Optionally, the active component 121 may further include a controller, an input/output interface, a power manager, another functional module, and the like. The included functional modules may be adjusted based on actual functions of the active component 121, and are not limited in this embodiment.

The passive component 122 is an electronic component that cannot actively input and output electrical energy or a signal. The passive component 122 may include a resistor, a capacitor, a sensor, a diode, a photosensitive component, a transistor, or the like.

During operating of the printed circuit board 100, the active component 121 usually needs to perform operation, control, energy conversion, and the like, resulting in a high power of the active component 121. In this case, heat generation of the active component 121 is greater than heat generation of the passive component 122. It can be learned that a main source generating heat when the printed circuit board 100 operates is the active component 121. When heat dissipation is performed on the printed circuit board 100, a heat dissipation effect on the active component 121 may be first improved.

It should be noted that a plurality of active components 121 and a plurality of passive components 122 may be disposed on one printed circuit board 100. Specific types and quantities of active components 121 and passive components 122 that are disposed on the printed circuit board 100 may be adjusted based on actual functions of the printed circuit board 100, and are not limited in this embodiment.

Refer to FIG. 3 and FIG. 4 again. According to a first aspect, this application provides a heat dissipation shielding structure 300. The heat dissipation shielding structure 300 includes an insulating layer 310 and a shielding layer 320 that are sequentially stacked.

To facilitate description of positions of structures inside the heat dissipation shielding structure 300, a coordinate system is established as an example based on the printed circuit board 100 in this application. As shown in FIG. 3 and FIG. 4, a thickness direction (a height direction of the electronic components 120) of the printed circuit board 100 is set as a z-axis direction, and a z axis is also a stacking direction of the insulating layer 310 and the shielding layer 320. A length direction of the printed circuit board 100 is set as an x-axis direction.

The active component 121 and the passive component 122 on the printed circuit board 100 each have a side surface, a top surface, and a bottom surface. A side surface that is of the active component 121 and that faces and is connected to the mounting surface 110 is disposed as the bottom surface, and a surface opposite to the bottom surface in the z-axis direction is the top surface. A surface between the bottom surface and the top surface is the side surface. The passive component 122 has a same arrangement.

For example, if the active component 121 is of a cubic structure, there is one top surface and one bottom surface, and the side surface is formed by four peripheral side surfaces between the top surface and the bottom surface. If the active component 121 is of a cylindrical structure, there is one top surface and one bottom surface, and the side surface is a curved surface between the top surface and the bottom surface. The passive component 122 has a same arrangement.

It may be understood that, in this embodiment, to facilitate description of internal structures of the printed circuit board 100 and the heat dissipation shielding structure 300, the structures provided in the accompanying drawings are schematic diagrams of structures obtained after the printed circuit board 100 and the heat dissipation shielding structure 300 are cut along a plane parallel to an x-z plane.

As shown in FIG. 3 and FIG. 4, the insulating layer 310 is covered on the mounting surface 110, to be connected to the printed circuit board 100.

The insulating layer 310 wraps the side surface and the top surface of the passive component 122, and the insulating layer 310 wraps the side surface and the top surface of the active component 121. In this way, the active component 121 and the passive component 122 can be isolated from each other by using the insulating layer 310 to avoid a short circuit.

When the insulating layer 310 wraps the side surface and the top surface of the active component 121, a side surface that is of the insulating layer 310 and that faces away from the mounting surface 110 can form a first surface 311. The first surface 311 undulatingly changes with different heights of the electronic components 120, that is, the first surface 311 may undulate with height variation of the active component 121 and the passive component 122 on the printed circuit board 100, so that the insulating layer 310 can implement contour-conforming coverage. A thickness of the insulating layer 310 on a surface of a shorter electronic component 120 can be further prevented from being excessively large when the insulating layer 310 is covered on the active component 121 and the passive component 122. In this way, local z-directional space can be saved, and a heat dissipation effect on the shorter electronic component 120 can be further improved.

Optionally, the thickness of the insulating layer 310 may be not less than 10 µm, to implement wrapping and isolation of the electronic components 120, thereby avoiding a short circuit.

For example, to facilitate heat dissipation of the electronic components 120 on the printed circuit board 100, a material of the insulating layer 310 may be a material whose thermal conductivity is greater than that of air, for example, polyimide, epoxy resin, polyethylene naphthalate, polytetrafluoroethylene, or polyvinyl chloride. In this way, efficiency of dissipating heat from the electronic components 120 can be improved by using the insulating layer 310, thereby improving a heat dissipation effect.

Optionally, the insulating layer 310 may be covered on the mounting surface 110 and the top surfaces of the electronic components 120 through high-temperature vacuum pressing, so that the insulating layer 310 can undulate with height variation of the electronic components 120 on the printed circuit board 100, to implement contour-conforming coverage. In this way, the electronic components 120 with different heights can be taken into account, and heat dissipation effects on the electronic components 120 with different heights can be simultaneously improved.

Alternatively, the insulating layer 310 may be covered on the mounting surface 110 and the top surfaces of the electronic components 120 by spraying an insulating adhesive, so that the insulating layer 310 can undulate with height variation of the electronic components 120 on the printed circuit board 100, to implement contour-conforming coverage. In this way, the electronic components 120 with different heights can be taken into account, and heat dissipation effects on the electronic components 120 with different heights can be simultaneously improved.

The shielding layer 320 is covered on the first surface 311, a shape of the shielding layer 320 matches a shape of the first surface 311, and the shielding layer 320 is electrically connected to a ground network of the printed circuit board 100. In this way, an undulating trend of the shielding layer 320 can match an undulating trend of the insulating layer 310 when the shielding layer 320 implements shielding cover 201 on the electronic components 120. In addition, because a thermal conductivity of the shielding layer 320 is usually 2-380 W/m·K, heat conduction performance of the shielding layer 320 is good, and heat of the electronic components 120 on the printed circuit board 100 can be better dissipated, thereby improving the heat dissipation effect.

It should be noted that the shape of the shielding layer 320 matches the shape of the first surface 311. It may be understood that the undulating trend of the shielding layer 320 is the same as an undulating trend of the first surface 311. Because the shielding layer 320 has a specific thickness compared with the first surface 311, the shape of the shielding layer 320 may be consistent with the shape of the first surface 311 if the thickness of the shielding layer 320 is extremely small, or the shape of the shielding layer 320 is similar to the shape of the first surface 311 if the thickness of the shielding layer 320 is slightly large.

It may be learned from comparison between FIG. 2 and FIG. 3 that the shielding cover 201 in FIG. 2 is in a regular shape. In this case, the shielding cover 201 can contact only the highest electronic component 120 on the printed circuit board 100. A distance between the shorter electronic component 120 on the printed circuit board 100 and the shielding cover 201 is large, resulting in a long path for the electronic component 120 to transfer heat to the shielding cover 201. Consequently, the heat of the shorter electronic component 120 is difficult to be dissipated, and the z-directional space is wasted.

In FIG. 3, the shape of the shielding layer 320 matches the shape of the first surface 311, and the shielding layer 320 can be simultaneously close to the electronic components 120 with different heights on the printed circuit board 100. In this way, the local z-directional space can be saved, paths for the electronic components 120 with different heights to transfer heat to the shielding layer 320 can be further shortened, thereby dissipating the heat from the electronic components 120 with different heights, and further comprehensively improving the heat dissipation effects on the electronic components 120 with different heights.

In addition, a thermal conductivity of the insulating layer 310 is usually 0.2-10 W/m·K, and the thermal conductivity of the air is about 0.024 W/m·K. It can be learned that the thermal conductivity of the air is far less than the thermal conductivity of the insulating layer 310. The insulating layer 310 is disposed between the shielding layer 320 and the electronic components 120 to isolate the electronic components 120 and perform heat conduction by using the insulating layer 310, thereby improving heat conduction efficiency between the electronic components 120 and the shielding layer 320, and improving the heat dissipation effects on the electronic components 120 on the printed circuit board 100.

For example, the shielding layer 320 may be a thin metal film or an electrical conductive film formed by a mixture of a resin material and metal particles. Metal may be elemental metal, for example, copper, nickel, chromium, aluminium, silver, or gold. Metal may alternatively be an alloy or a compound. A thermal conductivity of the thin metal film is about 380 W/m·K, and a thermal conductivity of the electrical conductive film formed by the metal particles and the resin material is about 2.5 W/m·K. It may be understood that a material of the shielding layer 320 may be selected according to an actual heat dissipation requirement, and is not limited in this embodiment.

Optionally, the thickness of the shielding layer 320 may be 1 µm-50 µm.

For example, the shielding layer 320 may be covered on the first surface 311 through high-temperature vacuum pressing, spraying, sputtering, or the like. This is not limited in this embodiment.

In this implementation provided in this application, the insulating layer 310 and the shielding layer 320 undulatingly change with the different heights of the electronic components 120, so that distances between the top surfaces of the electronic components 120 and the shielding layer 320 are similar to each other. In this way, the heat of the electronic components 120 can be transferred to the shielding layer 320 as soon as possible, thereby improving the heat dissipation effect. In addition, because the thermal conductivity of the insulating layer 310 is greater than the thermal conductivity of the air, the insulating layer 310 is disposed between the shielding layer 320 and the electronic components 120, to implement insulative isolation for the electronic components 120, and improve heat conduction efficiency between the electronic components 120 and the shielding layer 320, thereby improving the heat dissipation effect.

The heat generation of the active component 121 is greater than that of the passive component 122 during operating. In addition, because a thermal conductance of the shielding layer 320 is usually greater than that of the insulating layer 310, if the active component 121 can transfer the heat to the shielding layer 320 as soon as possible, transfer efficiency of the active component 121 in transferring the heat to the shielding layer 320 can be further improved, thereby improving the heat dissipation effect on the active component 121.

FIG. 6 is a schematic diagram of a second structure of a heat dissipation shielding structure and a printed circuit board according to an embodiment.

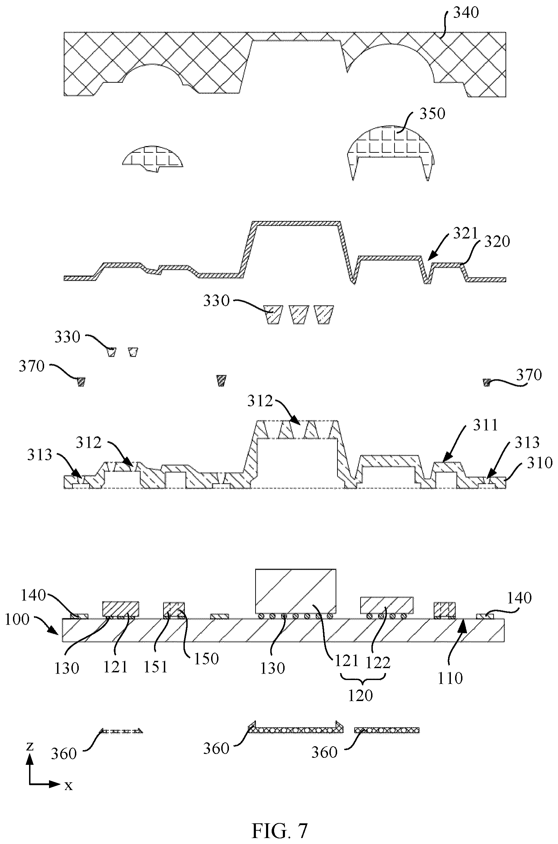

FIG. 7 is a schematic exploded view of FIG. 6.

As shown in FIG. 6 and FIG. 7, in an implementation, when the insulating layer 310 wraps the top surface and the side surface of the active component 121, a first trench 312 may be disposed on the insulating layer 310, and the first trench 312 is located between the top surface of the active component 121 and the shielding layer 320. In a direction perpendicular to the mounting surface 110 (the z-axis direction in FIG. 6), the first trench 312 runs through two sides of the insulating layer 310, and enables the top surface of the active component 121 to be in communication with the shielding layer 320. In this way, the shielding layer 320 may be connected to the top surface of the active component 121 through the first trench 312, thereby improving efficiency of the active component 121 in transferring the heat to the shielding layer 320, and further improving the heat dissipation effect on the active component 121.

Further, if a size of the active component 121 is small in the x-axis direction, one or two first trenches 312 may be disposed on the insulating layer 310 corresponding to the top surface of the active component 121. If a size of the active component 121 is large in the x-axis direction, a plurality of, for example, three or four, first trenches 312 may be disposed on the insulating layer 310 corresponding to the top surface of the active component 121. In this way, the first trench 312 may be disposed as much as possible, provided that space for disposing the first trench 312 allows, thereby improving heat conduction efficiency, and further improving the heat dissipation effect on the active component 121.

Optionally, the first trench 312 may be formed through laser etching, plasma etching, or the like. A size of a side that is of the first trench 312 and that is close to the top surface of the active component 121 may be greater than or equal to 0.1 mm in the x-axis direction.

In an example, the heat dissipation shielding structure 300 further includes a thermal conductive structure 330.

The thermal conductive structure 330 is embedded in the first trench 312, one end of the thermal conductive structure 330 is connected to the top surface of the active component 121, and the other end of the thermal conductive structure 330 is connected to the shielding layer 320. In this way, the heat of the active component 121 can be transferred to the shielding layer 320 by using the thermal conductive structure 330, thereby improving the heat dissipation effect on the active component 121.

Usually, a thermal conductivity of the thermal conductive structure 330 is greater than or equal to 5 W/m·K, and therefore heat conduction performance is good. The thermal conductive structure 330 is filled in the first trench 312, and a thermal conductance of the thermal conductive structure 330 is greater than a thermal conductance of the insulating layer 310, so that the thermal conductive structure 330 can be used to improve heat conduction efficiency between the active component 121 and the shielding layer 320, thereby improving the heat dissipation effect on the active component 121.

Optionally, a material of the thermal conductive structure 330 may be formed by filling a thermal conductive paste, metal particles, a thermal conductive gel, or the like in the first trench 312. The thermal conductive paste may be a silver paste, an alloy thermal conductive paste, a graphene thermal conductive paste, or the like.

If the material of the thermal conductive structure 330 is a material that is in a liquid state in a high temperature state, for example, the thermal conductive paste or the thermal conductive gel, the material in the liquid state may be directly filled in the first trench 312 and then solidified, to form the thermal conductive structure 330. If the thermal conductive structure 330 is made of the metal particles or the like, the metal particles may be melted at a high temperature and filled or the metal particles are directly disposed in the first trench 312.

For example, because the thermal conductive structure 330 is formed in the first trench 312 through filling, it can be learned that a shape of the thermal conductive structure 330 may change with a shape of the first trench 312. If the first trench 312 is of a boss structure, the thermal conductive structure 330 filled in the first trench 312 is also of a boss structure. If the first trench 312 is of a cylindrical structure, the thermal conductive structure 330 filled in the first trench 312 is also of a cylindrical structure. If the first trench 312 is of a prism structure, the thermal conductive structure 330 filled in the first trench 312 is also of a prism structure. It may be understood that the shapes of the first trench 312 and the thermal conductive structure 330 are not limited in this embodiment.

In another example, if the first trench 312 is disposed on the insulating layer 310 on the top surface of the active component 121, in addition to disposing the thermal conductive structure 330 in the first trench 312, the first surface 311 may alternatively be directly formed through the first trench 312. In this way, the shielding layer 320 is recessed in the first trench 312 or the shielding layer 320 protrudes in the first trench 312 to fill the first trench 312 and contact the top surface of the active component 121, so that the top surface of the active component 121 directly contacts the shielding layer 320, thereby improving the heat dissipation effect on the active component 121.

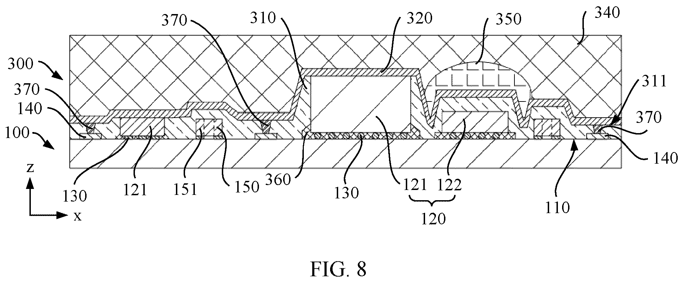

FIG. 8 is a schematic diagram of a third structure of a heat dissipation shielding structure and a printed circuit board according to an embodiment.

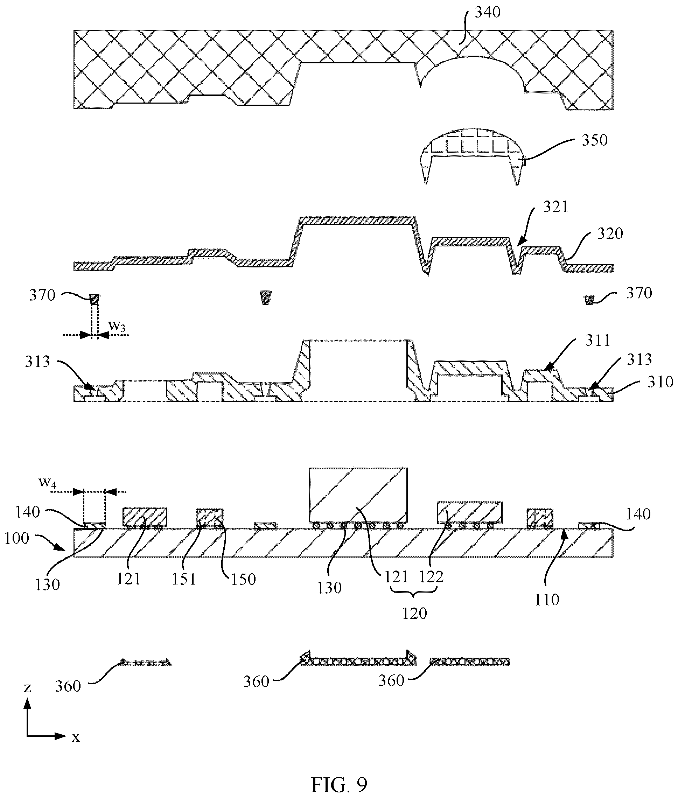

FIG. 9 is a schematic exploded view of FIG. 8.

As shown in FIG. 8 and FIG. 9, in another implementation, the insulating layer 310 wraps the side surface of the active component 121. In this case, a side that is of the insulating layer 310 and that faces away from the mounting surface 110 forms a first surface 311 together with the top surface of the active component 121, and the shielding layer 320 is covered on the top surface of the active component 121. In this way, the shielding layer 320 covered on the first surface 311 can directly contact the top surface of the active component 121, thereby further improving the heat dissipation effect on the active component 121.

As shown in FIG. 8 and FIG. 9, the heat dissipation shielding structure 300 further includes a graphite layer 340. The graphite layer 340 is covered on a side that is of the shielding layer 320 and that faces away from the first surface 311. In this way, heat at a position that is of the shielding layer 320 and that corresponds to the active component 121 can be rapidly dispersed to a surface of the graphite 204 through a thermal spreading effect of the graphite layer 340, to reduce a local temperature of the shielding layer 320, thereby preventing a hot spot and a cold spot from being generated, improving the heat dissipation effect on the active component 121, reducing generation of thermal stress, and preventing the shielding layer 320 from being deformed.

For example, a side that is of the graphite layer 340 and that faces away from the shielding layer 320 is a plane, and in the x-axis direction, sizes of the graphite layer 340 at various positions are different in the z axis, so that the graphite layer 340 can cover various positions of the shielding layer 320, thereby improving the heat dissipation effect. If the graphite layer 340 is not disposed, the side that is of the shielding layer 320 and that faces away from the first surface 311 is a main heat dissipation surface performing heat exchange with the air. The graphite layer 340 is disposed, so that the side that is of the graphite layer 340 and that faces away from the shielding layer 320 and a side surface of the graphite layer 340 can form a heat dissipation surface. In this way, a heat exchange area can be increased by using the graphite layer 340, thereby improving heat conduction efficiency and implementing more effective heat conduction and heat dissipation.

For example, a thickness of the graphite layer 340 may be 30 µm-100 µm. The graphite layer 340 may have different thicknesses corresponding to the electronic components 120 with different heights.

Still refer to FIG. 8 and FIG. 9. In some implementations, the heat dissipation shielding structure 300 further includes a thermal conductive gel 350. The thermal conductive gel 350 is disposed between the shielding layer 320 and the graphite layer 340.

Because the shielding layer 320 and the insulating layer 310 are used for contour-conforming coverage, the insulating layer 310 and the shielding layer 320 greatly undulate at a gap position between two adjacent electronic components 120 or at a local position due to a height difference between two adjacent electronic components 120.

When the graphite layer 340 is covered on the shielding layer 320, because the graphite layer 340 may not completely fill a greatly undulated position of the shielding layer 320, there is an air gap between the shielding layer 320 and the graphite layer 340, and therefore heat conduction efficiency is affected.

Because the thermal conductive gel 350 is disposed between the graphite layer 340 and the shielding layer 320, the greatly undulated position of the shielding layer 320 may be filled based on fluidity of the thermal conductive gel 350 to avoid the air gap. In this way, a thermal conductivity of the thermal conductive gel 350 may be greater than the thermal conductivity of the air, thereby improving heat conduction efficiency and the heat dissipation effect.

For example, the greatly undulated position of the shielding layer 320 forms a concave portion 321. The concave portion 321 is usually close to an edge of the electronic component 120, and is recessed toward the insulating layer 310. In the z-axis direction, a depth of the concave portion 321 is usually deeper than another position. When the graphite layer 340 is used for coverage, the graphite layer 340 is difficult to completely fill the concave portion 321, and therefore the air gap easily occurs in the concave portion 321. The thermal conductive gel 350 is filled in at least the concave portion 321 to prevent the air gap from occurring in the concave portion 321, thereby improving heat conduction efficiency and the heat dissipation effect.

As shown in FIG. 8, the thermal conductive gel 350 may be disposed at one position between the shielding layer 320 and the graphite layer 340. Alternatively, as shown in FIG. 6, the thermal conductive gel 350 may be disposed at two positions between the shielding layer 320 and the graphite layer 340. Alternatively, the thermal conductive gel 350 may be disposed at all positions between the shielding layer 320 and the graphite layer 340 to form a thermal conductive gel layer, to reduce an undulating degree of the side that is of the shielding layer 320 and that faces away from the first surface 311, thereby facilitating tight adherence of the graphite layer 340.

It may be understood that a position and an area for disposing the thermal conductive gel 350 may be adjusted according to an actual situation, and are not limited in this embodiment.

Still refer to FIG. 8 and FIG. 9. In some implementations, the heat dissipation shielding structure 300 further includes a protective structure 360.

The protective structure 360 is filled in a gap between a bottom surface of the electronic component 120 and the mounting surface 110, and the protective structure 360 surrounds the electrical connection structure 130 and is connected to the electronic component 120 and the printed circuit board 100.

When the insulating layer 310 is covered on the mounting surface 110, if fluidity of an insulating material is not high, a specific air gap exists between a bottom of the electronic component 120 and the mounting surface 110. The foregoing problem can be avoided by disposing the protective structure 360. In other words, the gap between the electronic component 120 and the mounting surface 110 is filled in advance by using the protective structure 360, so that a fluidity requirement for the insulating material can be lowered.

In addition, because the protective structure 360 surrounds the electrical connection structure 130, the protective structure 360 can further improve reliability of the electrical connection structure 130. If the electrical connection structure 130 is deformed under the action of an external force, the protective structure 360 may absorb a part of the external force, thereby reducing a possibility of deforming the electrical connection structure 130.

In addition, the electronic components 120 may undergo a downward pressure when the insulating layer 310, the shielding layer 320, and the graphite layer 340 are formed. The electronic component 120 is mainly connected to the mounting surface 110 by using a connection structure. When the downward pressure is generated, the protective structure 360 may be filled between the bottom of the electronic component 120 and the mounting surface 110 to prevent the connection structure from being crushed due to an excessively large downward pressure. In this way, the protective structure 360 may surround the connection structure to support the electronic component 120 and protect the connection structure.

Optionally, to prevent the protective structure 360 from affecting electrical connection between the electronic component 120 and the printed circuit board 100, a material of the protective structure 360 should be an insulating material, thereby implementing insulative protection on each electrical connection structure 130.

For example, a material of the protective structure 360 may be an under-fill (Under-fill, UF for short) adhesive. The under-fill adhesive may be silicone, polyurethane adhesive, acrylic adhesive, or the like. The UF adhesive in a liquid state can fill the gap between the bottom of the electronic component 120 and the mounting surface 110 to surround the connection structure. The UF adhesive may be cured after filling, to form the protective structure 360 in a solid state, thereby supporting the electronic component 120.

In addition, the under-fill adhesive has a small modulus, and is used for buffering between a chip, a solder joint, and the PCB, thereby improving reliability of the solder joint (preventing cracking). In a procedure of disposing the insulating layer 310, the shielding layer 320, or the graphite layer 340, expansion does not occur due to a high-temperature environment, and expansion stress is prevented from being generated between the bottom of the electronic component 120 and the mounting surface 110 due to expansion, thereby further improving stability of connection between the electronic component 120 and the mounting surface 110.

Still refer to FIG. 8 and FIG. 9. In some implementations, a ground pad 140 is mounted on the mounting surface 110 of the printed circuit board 100, and the shielding layer 320 is electrically connected to the ground pad 140. The shielding layer 320 can be grounded by using the ground pad 140 on the mounting surface 110 without additionally disposing another ground structure. In this way, the printed circuit board 100 and the heat dissipation shielding structure 300 are simplified and miniaturization design of the printed circuit board 100 may be further implemented.

As shown in FIG. 8 and FIG. 9, in a first implementation, a second trench 313 is disposed on the insulating layer 310, and the second trench 313 is located between a top surface of the ground pad 140 and the shielding layer 320, and enables the top surface of the ground pad 140 to be in communication with the shielding layer 320.

It may be understood that, for a formation manner and a size of the second trench 313, refer to those of the first trench 312. Details are not described herein again.

A first electrical conductive structure 370 is filled in the second trench 313, and the first electrical conductive structure 370 is electrically connected to the ground pad 140 and the shielding layer 320. In this way, the shielding layer 320 can be electrically connected to the ground pad 140 by using the first electrical conductive structure 370.

In an example, one end of the first electrical conductive structure 370 is connected to the top surface of the ground pad 140, and the other end of the first electrical conductive structure 370 is connected to the shielding layer 320. In this way, the shielding layer 320 can be electrically connected to the ground pad 140 by using the first electrical conductive structure 370. In addition, disposing the first electrical conductive structure 370 can further narrow ground space of the shielding layer 320, to reduce an area occupied on the mounting surface 110, thereby implementing miniaturization design of the printed circuit board 100.

A material of the first electrical conductive structure 370 may be an electrical conductive paste, for example, a silver paste, a carbon paste, a copper paste, a gold paste, or an electrical conductive adhesive.

The first electrical conductive structure 370 may be formed in the second trench 313 through spraying, printing, or the like.

As shown in FIG. 2, when the shielding cover 201 with a regular shape and the printed circuit board 100 are grounded, the connection pillar 2011 on the shielding cover 201 may be connected to the ground pad 140 on the printed circuit board 100. However, because the shielding cover 201 is usually of an integrally formed structure, affected by a production process, a size w1 of the connection pillar 2011 in the x-axis direction usually needs to be 0.4 mm-0.5 mm. In this case, a size w2 of the ground pad 140 needs to be at least greater than 0.5 mm.

As shown in FIG. 8 and FIG. 9, because the first electrical conductive structure 370 is formed in the second trench 313 through filling, a size of the first electrical conductive structure 370 depends on a size of the second trench 313. The second trench 313 may be formed through laser etching, plasma etching, or the like. In this case, a minimum size w3 of the second trench 313 on the ground pad 140 in the x-axis direction may be 0.1 mm. In other words, a minimum size of the first electrical conductive structure 370 may be 0.1 mm. Considering a processing error, a size w4 of the ground pad 140 along an x axis may be 0.2 mm. The size of the ground pad 140 may be significantly reduced, so that space occupied on the mounting surface 110 of the printed circuit board 100 can be narrowed.

In addition, the electronic component 120 further exists around the connection pillar 2011 in FIG. 2. When the connection pillar 2011 is connected to the ground pad 140, the connection pillar 2011 may damage the electronic component 120 close to the ground pad 140, resulting in a decrease in a product yield.

Compared with the structure in FIG. 2, the first electrical conductive structure 370 in FIG. 8 is surrounded by the insulating layer 310, and an electronic component 120 close to the first electrical conductive structure 370 is also surrounded by the insulating layer 310. The insulating layer 310 can further protect the electronic components 120, to prevent a peripheral electronic component 120 from being affected when the second trench 313 and the first electrical conductive structure 370 are formed. In this way, the product yield can be increased, thereby improving safety and reliability of the printed circuit board 100 and the heat dissipation shielding structure 300.

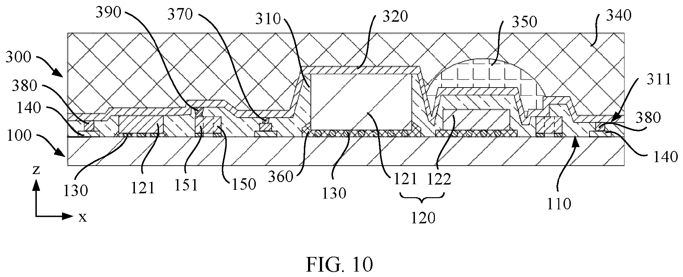

FIG. 10 is a schematic diagram of a fourth structure of a heat dissipation shielding structure and a printed circuit board according to an embodiment.

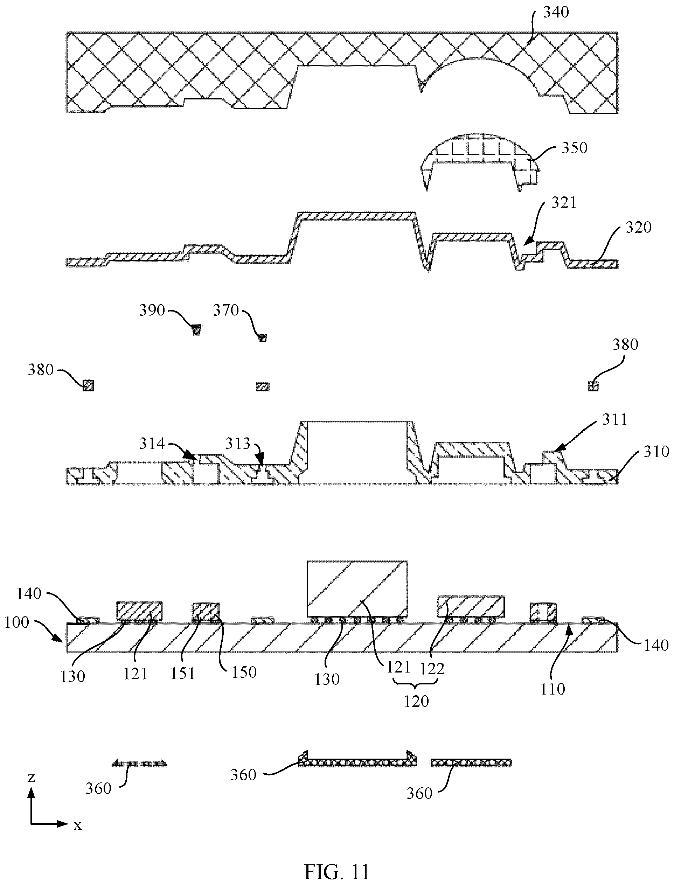

FIG. 11 is an exploded view of FIG. 10.

As shown in FIG. 10 and FIG. 11, in another example, the heat dissipation shielding structure 300 further includes an electrical conductive cushion block 380.

The electrical conductive cushion block 380 is disposed on the top surface of the ground pad 140, and the insulating layer 310 wraps a side surface and a top surface of the electrical conductive cushion block 380.

The second trench 313 is located between the top surface of the electrical conductive cushion block 380 and the shielding layer 320, and enables the top surface of the electrical conductive cushion block 380 to be in communication with the shielding layer 320.

The first electrical conductive structure 370 is filled in the second trench 313, one end of the first electrical conductive structure 370 is connected to the top surface of the electrical conductive cushion block 380, and the other end of the first electrical conductive structure 370 is connected to the shielding layer 320. In this way, a distance between the shielding layer 320 and the ground pad 140 can be shortened by using the electrical conductive cushion block 380, to prevent the second trench 313 from being excessively deep, thereby facilitating filling of the first electrical conductive structure 370 and grounding the shielding layer 320.

Optionally, the electrical conductive cushion block 380 may be a tin block, a copper block, a silver block, a carbon block, an electrical conductive adhesive block, or the like.

Refer to FIG. 10 and FIG. 11 again. In a second implementation, the heat dissipation structure further includes an electrical conductive cushion block 380.

The electrical conductive cushion block 380 is disposed on the top surface of the ground pad 140; the insulating layer 310 wraps a side surface of the electrical conductive cushion block 380; a top surface of the electrical conductive cushion block 380 is located on the first surface 311; and the shielding layer 320 is connected to the electrical conductive cushion block 380. It can be learned that when a size of the electrical conductive cushion block 380 is the same as a distance between the top surface of the ground pad 140 and the first surface 311 in the z-axis direction, the top surface of the electrical conductive cushion block 380 may be located on the first surface 311. In this way, when the shielding layer 320 may be electrically connected to the ground pad 140 by using the electrical conductive cushion block 380, the shielding layer 320 may directly contact the top surface of the electrical conductive cushion block 380 without disposing the first electrical conductive structure 370.

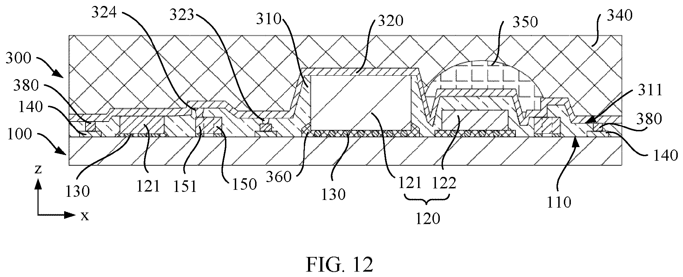

FIG. 12 is a schematic diagram of a fifth structure of a heat dissipation shielding structure and a printed circuit board according to an embodiment.

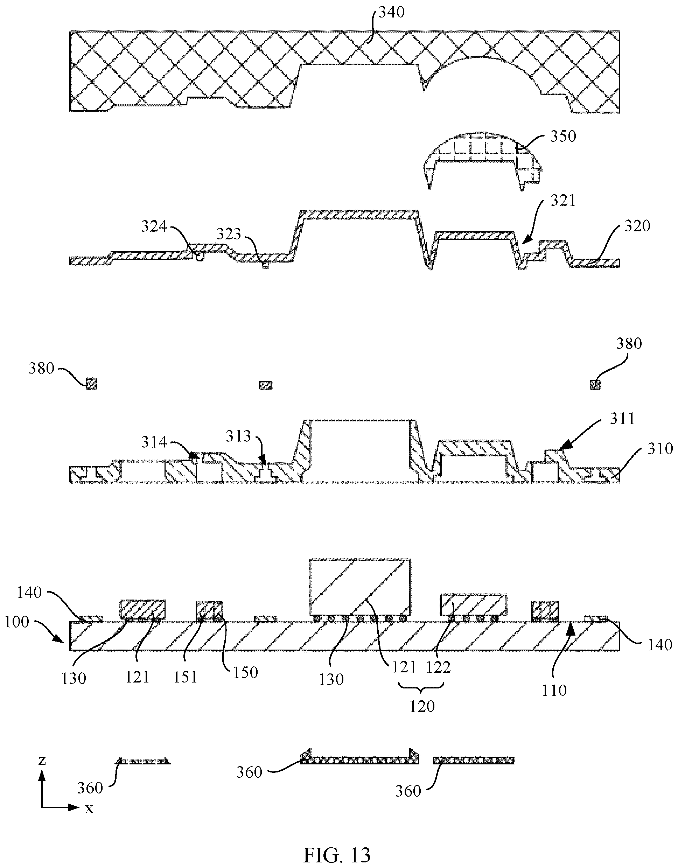

FIG. 13 is an exploded view of FIG. 12.

As shown in FIG. 12 and FIG. 13, in a third implementation, a second trench 313 is disposed on the insulating layer 310, and the second trench 313 is located between a top surface of the ground pad 140 and the shielding layer 320, and enables the top surface of the ground pad 140 to be in communication with the shielding layer 320.

In an example, the shielding layer 320 includes a main body portion 322 and a first electrical conductive portion 323.

The main body portion 322 is covered on the first surface 311, and a shape of the main body portion 322 matches the shape of the first surface 311.

The first electrical conductive portion 323 is filled in the second trench 313, one end of the first electrical conductive portion 323 is connected to the main body portion 322, and the other end of the first electrical conductive portion 323 is connected to the top surface of the ground pad 140. In this way, the shielding layer 320 may be directly connected to the ground pad 140 through the second trench 313, so that the shielding layer 320 is grounded.

For example, to facilitate simultaneous formation of the main body portion 322 and the first electrical conductive portion 323, the shielding layer 320 may be formed on the first surface 311 in a spraying or sputtering manner.

In another example, a second trench 313 is disposed on the insulating layer 310, and the second trench 313 is located between a top surface of the ground pad 140 and the shielding layer 320, and enables the top surface of the ground pad 140 to be in communication with the shielding layer 320. In this case, the shielding layer 320 may be directly bent and recessed toward the second trench 313, to be connected to the top surface of the ground pad 140. Therefore, the shielding layer 320 is directly connected to the ground pad 140 without adding an additional structure, thereby facilitating processing.

For example, to facilitate bending and recessing toward the second trench 313, the shielding layer 320 may be formed on the first surface 311 in a high-temperature vacuum pressing manner.

Refer to FIG. 10 and FIG. 11 again. In a fourth implementation, the passive component 122 includes a capacitor 150.

The capacitor 150 has a ground terminal 151, and the shielding layer 320 is electrically connected to the ground terminal 151. In this way, the shielding layer 320 can be grounded by using the capacitor 150 without additionally disposing a ground structure, thereby facilitating miniaturization design of the printed circuit board 100.

In an example, a third trench 314 is disposed on the insulating layer 310, and the third trench 314 is located between a top surface of the ground terminal 151 and the shielding layer 320, and enables the top surface of the ground terminal 151 to be in communication with the shielding layer 320.

It may be understood that, for a formation manner and a size of the third trench 314, refer to those of the first trench 312. Details are not described herein again.

A second electrical conductive structure 390 is filled in the third trench 314, one end of the second electrical conductive structure 390 is connected to the top surface of the ground terminal 151, and the other end of the second electrical conductive structure 390 is connected to the shielding layer 320. In this way, the shielding layer 320 can be electrically connected to the ground terminal 151 by using the second electrical conductive structure 390.

It should be noted that for a material, a formation manner, and a size of the second electrical conductive structure 390, refer to those of the first electrical conductive structure 370. Details are not described herein again.

Refer to FIG. 12 and FIG. 13 again. In another example, a third trench 314 is disposed on the insulating layer 310, and the third trench 314 is located between a top surface of the ground terminal 151 and the shielding layer 320, and enables the top surface of the ground terminal 151 to be in communication with the shielding layer 320.

The shielding layer 320 includes a main body portion 322 and a second electrical conductive portion 324.

The main body portion 322 is covered on the first surface 311, and a shape of the main body portion 322 matches the shape of the first surface 311.

The second electrical conductive portion 324 is filled in the third trench 314, one end of the second electrical conductive portion 324 is connected to the main body portion 322, and the other end of the second electrical conductive portion 324 is connected to the top surface of the ground terminal 151. In this way, the shielding layer 320 can be directly connected to the ground terminal 151, so that the shielding layer 320 is grounded.

For example, to facilitate simultaneous formation of the main body portion 322 and the second electrical conductive portion 324, the shielding layer 320 may be formed on the first surface 311 in a spraying or sputtering manner.

In another example, a third trench 314 is disposed on the insulating layer 310, and the third trench 314 is located between a top surface of the ground terminal 151 and the shielding layer 320, and enables the top surface of the ground terminal 151 to be in communication with the shielding layer 320. In this case, the shielding layer 320 may be directly bent and recessed toward the third trench 314, to be connected to the top surface of the ground terminal 151. Therefore, the shielding layer 320 is directly connected to the ground terminal 151 without adding an additional structure, thereby facilitating processing.

For example, to facilitate bending and recessing toward the third trench 314, the shielding layer 320 may be formed on the first surface 311 in a high-temperature vacuum pressing manner.

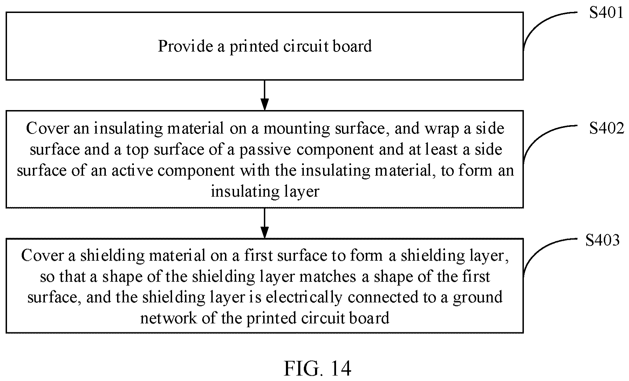

FIG. 14 is a flowchart of a first processing method of a heat dissipation shielding structure according to an embodiment.

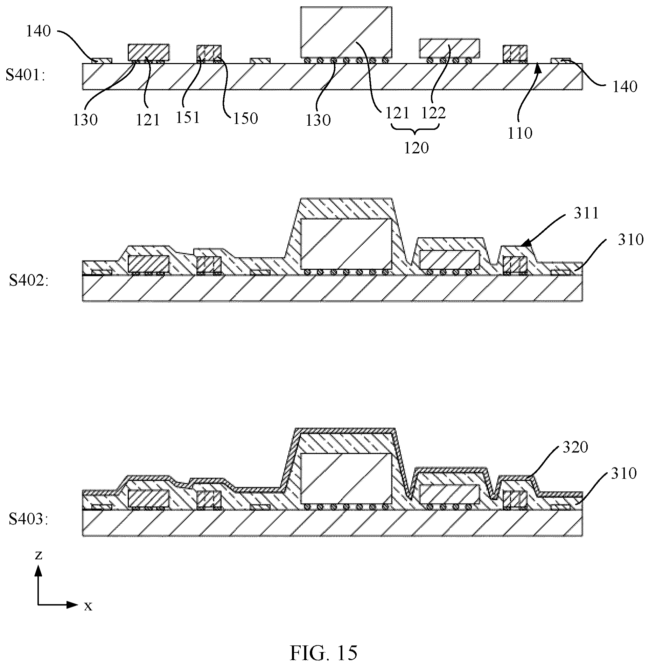

FIG. 15 is a diagram of a first procedure of processing a heat dissipation shielding structure on a printed circuit board according to an embodiment.

As shown in FIG. 14 and FIG. 15, this embodiment provides a processing method of a heat dissipation shielding structure 300, including the following steps.

Step S401: Provide a printed circuit board 100.

The printed circuit board 100 includes a mounting surface 110, electronic components 120 are mounted on the mounting surface 110, the electronic components 120 include an active component 121 and a passive component 122, and heat generation of the active component 121 is greater than heat generation of the passive component 122.

Step S402: Cover an insulating material on a mounting surface 110, wrap a side surface and a top surface of a passive component 122 and wrap at least a side surface of an active component 121 with the insulating material, to form an insulating layer 310.

When the insulating layer 310 is formed, a side that is of the insulating layer 310 and that faces away from the mounting surface 110 may form a first surface 311 or a side that is of the insulating layer 310 and that faces away from the mounting surface 110 forms a first surface 311 together with a top surface of the active component 121. In this way, the insulating layer 310 may be used to perform insulative isolation on the electronic components 120 on the printed circuit board 100, and heat conduction efficiency of the electronic components 120 can be further improved by using the insulating layer 310.

In addition, the first surface 311 undulatingly changes with different heights of the electronic components 120. In this way, the insulating layer 310 can implement contour-conforming coverage on the electronic components 120, to narrow z-directional space occupied by the insulating layer 310, thereby implementing miniaturization design of the printed circuit board 100 and the heat dissipation shielding structure.

In an implementation, the insulating material may be a layer of insulating film.

After the printed circuit board 100 on which the electronic components 120 are mounted is obtained, a high-temperature environment, for example, 120°C-150°C, may be provided for the insulating film, to heat the insulating film, thereby softening the insulating film.

After the insulating film is softened, the softened insulating film may be pressed onto surfaces of the electronic components 120 according to a vacuum pressing technology by using a pressing structure with a soft surface. In this case, vacuumization is performed on a side of the printed circuit board 100, so that the softened insulating film can be filled in a gap between two adjacent electronic components 120. In this way, the insulating film can wrap the side surface and the top surface of the passive component 122 and can further wrap the side surface and the top surface of the active component 121, to form the insulating layer 310.

Optionally, a thickness of the insulating film is 20 µm-300 µm before the insulating film is heated. In this way, the insulating film can be prevented from being broken through pulling during subsequent pressing and vacuumization, thereby implementing continuous coverage of the insulating film.

In another implementation, the insulating material may be an insulating adhesive.

After the printed circuit board 100 on which the electronic components 120 are mounted is obtained, the side surface and the top surface of the passive component 122 and the side surface and the top surface of the active component 121 can be wrapped by the insulating adhesive in a spraying manner, to form the insulating layer 310.

Optionally, a minimum thickness of the insulating layer 310 on the top surfaces or the side surfaces of the electronic components 120 should be not less than 10 µm, to prevent the insulating layer 310 from being damaged in a subsequent operating procedure, affecting insulation performance.

Optionally, a material of the insulating layer 310 may be a material whose thermal conductivity is greater than that of air, for example, polyimide, epoxy resin, polyethylene naphthalate, polytetrafluoroethylene, or polyvinyl chloride.

Step S403: Cover a shielding material on a first surface 311 to form a shielding layer 320, so that a shape of the shielding layer 320 matches a shape of the first surface 311, and the shielding layer 320 is electrically connected to a ground network of the printed circuit board 100.

The shape of the shielding layer 320 matches that of the first surface 311, so that the shielding layer 320 can perform contour-conforming coverage on the insulating layer 310. In addition, contour-conforming coverage of the insulating layer 310 can enable distances between the electronic components 120 with different heights and the shielding layer 320 to be similar, to prevent a higher component from being close to the shielding layer 320, and prevent a shorter component from being away from the shielding layer 320.

Optionally, a thickness of the shielding layer 320 may be 1 µm-50 µm.

For example, the shielding layer 320 may be a thin metal film or an electrical conductive film formed by a mixture of a resin material and metal particles. Metal may be elemental metal, for example, copper, nickel, chromium, aluminium, silver, or gold. Metal may alternatively be an alloy or a compound.

In an example, if the shielding material is of a thin film structure before the shielding layer 320 is formed, the shielding material may be covered on the first surface 311 in a high-temperature vacuum pressing manner to form the shielding layer 320.

In another example, if the shielding material is metal particles or a liquid paste before the shielding layer 320 is formed, the shielding material may be covered on the first surface 311 in a spraying or sputtering manner to form the shielding layer 320.

In this embodiment, the insulating layer 310 and the shielding layer 320 undulatingly change with height variation of the electronic components 120, to implement contour-conforming coverage for the printed circuit board 100. In this way, the distances between the electronic components 120 with different heights and the shielding layer 320 may be similar, thereby improving heat conduction efficiency of the electronic components 120 and improving a heat dissipation effect. In addition, contour-conforming coverage further helps save the z-directional space. Therefore, space above the shorter electronic component 120 can be saved, thereby implementing miniaturization design of the printed circuit board 100, a circuit board assembly, and an electronic device.

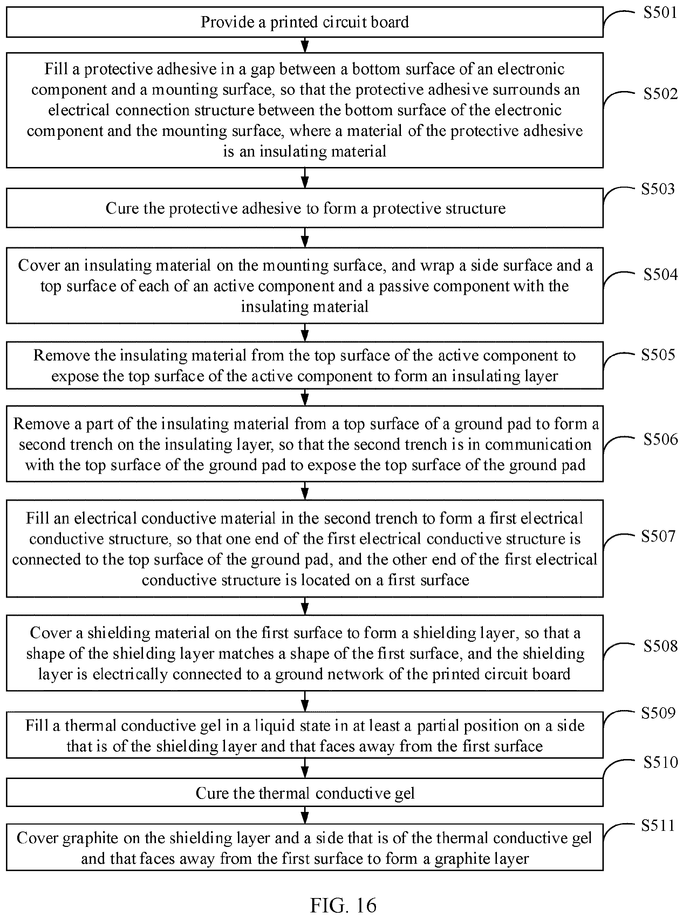

FIG. 16 is a flowchart of a second processing method of a heat dissipation shielding structure according to an embodiment.

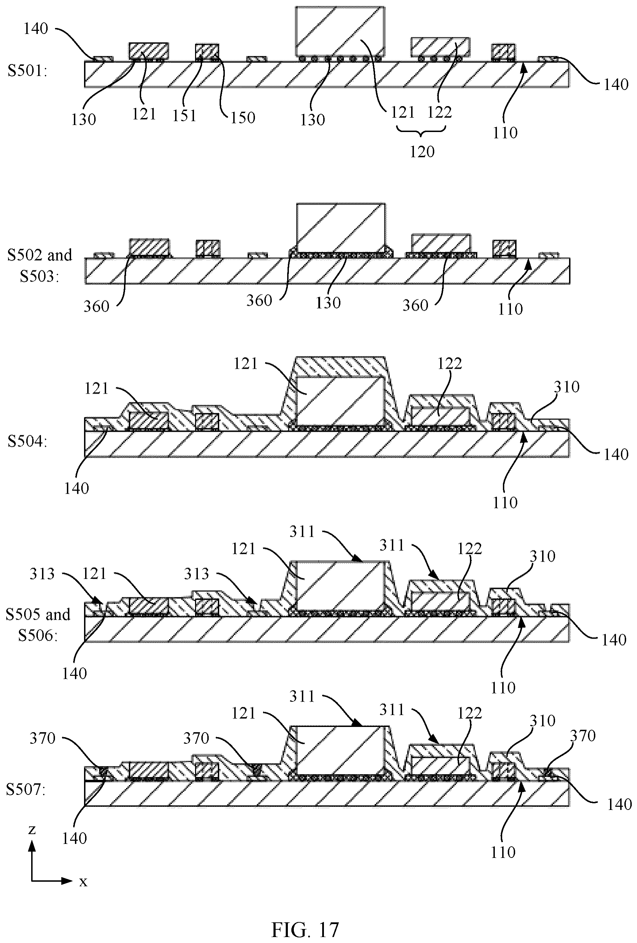

FIG. 17 shows a first partial procedure of a diagram of a second procedure of processing a heat dissipation shielding structure on a printed circuit board according to an embodiment.

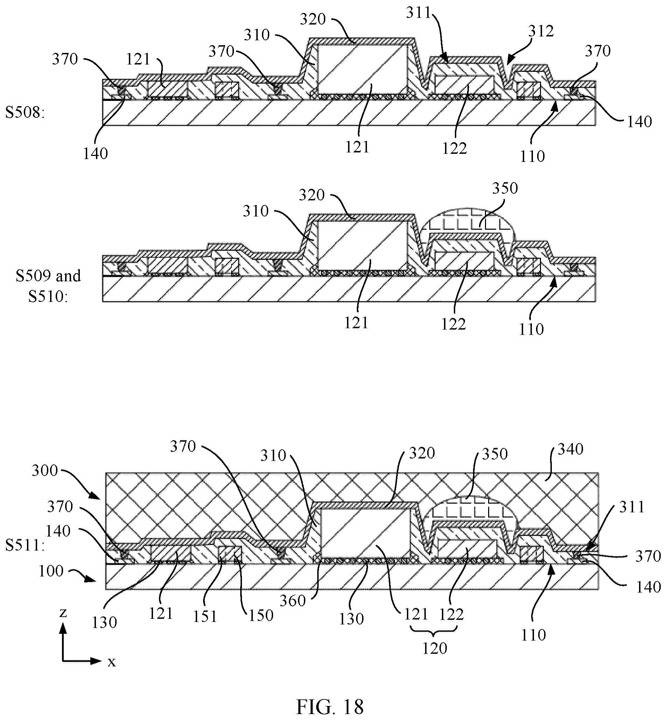

FIG. 18 shows a second partial procedure of a diagram of a second procedure of processing a heat dissipation shielding structure on a printed circuit board according to an embodiment.

As shown in FIG. 16 to FIG. 18, this embodiment further provides a processing method of a heat dissipation shielding structure 300, including the following steps.

Step S501: Provide a printed circuit board 100.

The printed circuit board 100 includes a mounting surface 110, electronic components 120 are mounted on the mounting surface 110, the electronic components 120 include an active component 121 and a passive component 122, and heat generation of the active component 121 is greater than heat generation of the passive component 122. The passive component 122 includes a capacitor 150, the capacitor 150 includes a ground terminal 151, and a ground pad 140 is mounted on the mounting surface 110 of the printed circuit board 100.

When the printed circuit board 100 is provided, the electronic components 120 on the printed circuit board 100 are already mounted on the mounting surface 110. However, in a mounting procedure, it is inevitable that some impurities such as flux and oil stains are remained on the mounting surface 110. Before being covered by the heat dissipation shielding structure 300, the mounting surface 110 of the printed circuit board 100 needs to be cleaned first, so that the impurities such as the flux and the oil stains remaining on the mounting surface 110 are cleared, thereby facilitating subsequent mounting of the heat dissipation shielding structure 300.

Step S502: Fill a protective adhesive in a gap between a bottom surface of an electronic component 120 and a mounting surface 110, so that the protective adhesive surrounds an electrical connection structure 130 connecting the bottom surface of the electronic component 120 and the mounting surface 110, where a material of the protective adhesive is an insulating material.

For example, the protective adhesive may be an under-fill (Under-fill, UF for short) adhesive. The under-fill adhesive may be silicone, polyurethane adhesive, acrylic adhesive, or the like. The UF adhesive in a liquid state can fill the gap between the bottom of the electronic component 120 and the mounting surface 110 to surround the connection structure.

In addition, because the UF adhesive has a small thermal expansion coefficient, the UF adhesive does not expand due to a high-temperature environment in a subsequent processing procedure, and expansion stress is prevented from being generated between the bottom of the electronic component 120 and the mounting surface 110 due to expansion, thereby further improving stability of connection between the electronic component 120 and the mounting surface 110.

Step S503: Cure the protective adhesive to form a protective structure 360.

The protective adhesive may be cured after filling, to form the protective structure 360 in a solid state, to support the electronic component 120.

For example, a curing procedure may be light curing, air drying curing, or the like. A material and a characteristic of the protective adhesive need to be considered for a specific method. This is not limited in this embodiment.

Step S504: Cover an insulating material on the mounting surface 110, and wrap a side surface and a top surface of each of an active component 121 and a passive component 122 with the insulating material.

It may be understood that for an example and a specific coverage manner of the insulating material, refer to the description in step S402. Details are not described herein again.

Step S505: Remove the insulating material from the top surface of the active component 121 to expose the top surface of the active component 121 to form an insulating layer 310.

In this way, a side that is of the insulating layer 310 and that faces away from the mounting surface 110 forms a first surface 311 together with the top surface of the active component 121, and the first surface 311 undulatingly changes with different heights of the electronic components 120.

For example, the insulating material is removed from the top surface of the active component 121 through laser etching or plasma etching. This is not limited in this embodiment.

Step S506: Remove a part of the insulating material from a top surface of a ground pad 140 to form a second trench 313 on the insulating layer 310, so that the second trench 313 is in communication with the top surface of the ground pad 140 to expose the top surface of the ground pad 140.

It may be understood that step S506 and step S505 may be synchronously performed.

Step S507: Fill an electrical conductive material in the second trench 313 to form a first electrical conductive structure 370, so that one end of the first electrical conductive structure 370 is connected to the top surface of the ground pad 140, and the other end of the first electrical conductive structure 370 is located on the first surface 311.

For example, the electrical conductive material may be an electrical conductive paste, for example, a silver paste, a carbon paste, a copper paste, a gold paste, or an electrical conductive adhesive.

Optionally, the electrical conductive material may be filled in the second trench 313 through spraying, printing, or the like. This is not limited in this embodiment.

Step S508: Cover a shielding material on the first surface 311 to form a shielding layer 320, so that a shape of the shielding layer 320 matches a shape of the first surface 311, and the shielding layer 320 is electrically connected to a ground network of the printed circuit board 100.

It may be understood that step S507 may be omitted. In this way, the shielding material may be synchronously filled in the second trench 313 in step S508, so that the shielding layer 320 can directly contact the top surface of the ground pad 140.

For example, the shielding material filled in the second trench 313 may be directly used as the shielding layer 320 if the shielding material is a thin metal film, so that the shielding layer 320 directly contacts the top surface of the ground pad 140, and the shielding layer 320 is grounded. The shielding material filled in the second trench 313 may form a first electrical conductive portion 323 of the shielding layer 320 if the shielding material is an electrical conductive paste, and the shielding material covered on the first surface 311 forms a main body portion 322 of the shielding layer 320. The first electrical conductive portion 323 is connected to the main body portion 322 and the top surface of the ground pad 140, so that the shielding layer 320 is grounded.

Step S509: Fill a thermal conductive gel 350 in a liquid state in at least a partial position on a side that is of the shielding layer 320 and that faces away from the first surface 311.

For example, the thermal conductive gel 350 may be filled in a specified position in a coating manner. The specified position may be a position in which the shielding layer 320 has a concave portion 321, so that the thermal conductive gel 350 is filled in the concave portion 321, thereby preventing a heat dissipation effect from being affected by an air gap.

Step S510: Cure the thermal conductive gel 350.

Step S511: Cover graphite 204 on the shielding layer 320 and a side that is of the thermal conductive gel 350 and that faces away from the first surface 311 to form a graphite layer 340.

The graphite layer 340 is covered on a side that is of the shielding layer 320 and that faces away from the first surface 311. In this way, heat at a position that is of the shielding layer 320 and that corresponds to the active component 121 can be rapidly dispersed to a surface of the graphite 204 through a thermal spreading effect of the graphite layer 340, to reduce a local temperature of the shielding layer 320, thereby preventing a hot spot and a cold spot from being generated, improving the heat dissipation effect on the active component 121, reducing generation of thermal stress, and preventing the shielding layer 320 from being deformed.

In addition, the graphite layer 340 can further increase a heat exchange area with air, thereby further improving the heat dissipation effect.

For example, a thickness of the graphite layer 340 may be 30 µm-100 µm. The graphite layer 340 may have different thicknesses corresponding to the electronic components 120 with different heights.

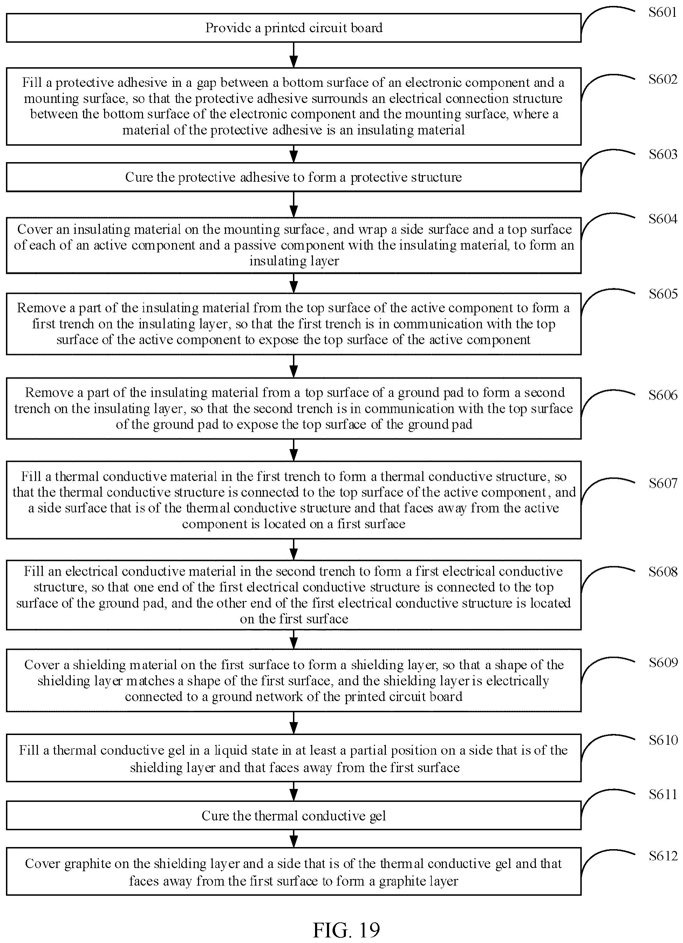

FIG. 19 is a flowchart of a third processing method of a heat dissipation shielding structure according to an embodiment.

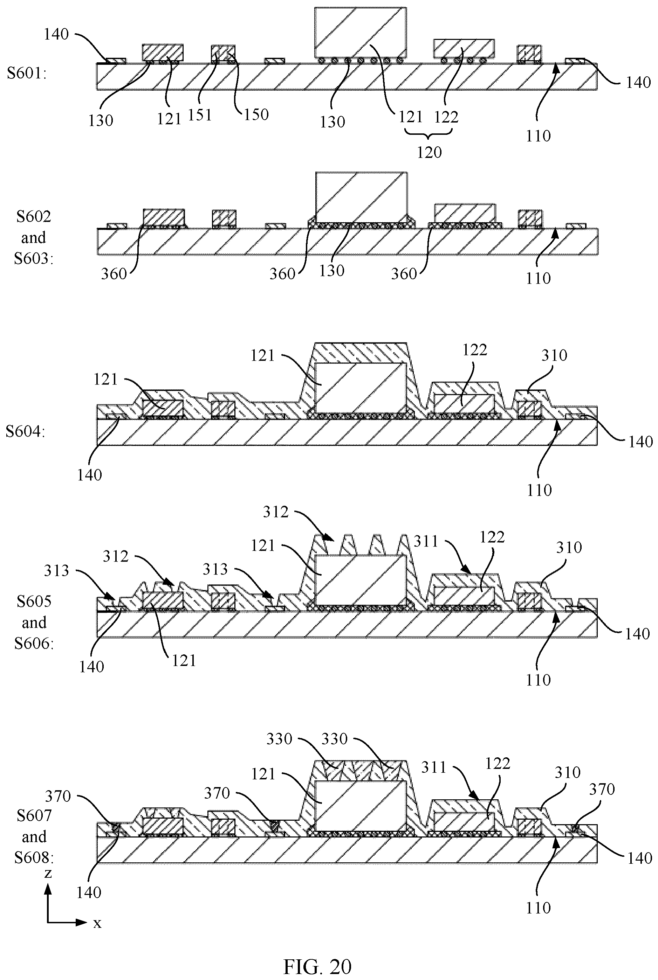

FIG. 20 shows a first partial procedure of a diagram of a third procedure of processing a heat dissipation shielding structure on a printed circuit board according to an embodiment.

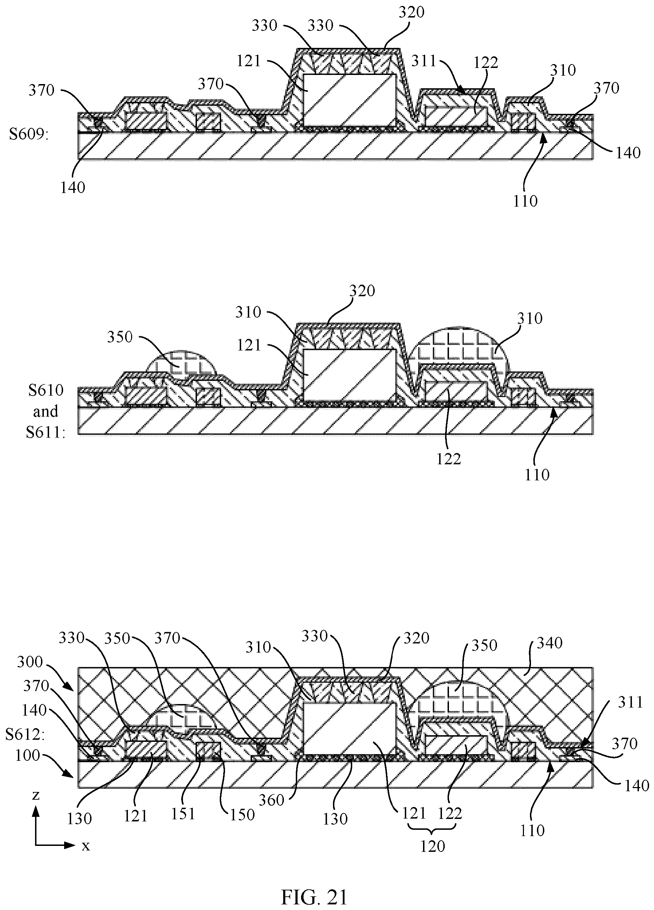

FIG. 21 shows a second partial procedure of a diagram of a third procedure of processing a heat dissipation shielding structure on a printed circuit board according to an embodiment.

As shown in FIG. 19 to FIG. 21, this embodiment further provides a processing method of a heat dissipation shielding structure 300, including the following steps.

Step S601: Provide a printed circuit board 100.

The printed circuit board 100 includes a mounting surface 110, electronic components 120 are mounted on the mounting surface 110, the electronic components 120 include an active component 121 and a passive component 122, and heat generation of the active component 121 is greater than heat generation of the passive component 122. The passive component 122 includes a capacitor 150, the capacitor 150 includes a ground terminal 151, and a ground pad 140 is mounted on the mounting surface 110 of the printed circuit board 100.

Step S602: Fill a protective adhesive in a gap between a bottom surface of an electronic component 120 and a mounting surface 110, so that the protective adhesive surrounds an electrical connection structure 130 connecting the bottom surface of the electronic component 120 and the mounting surface 110, where a material of the protective adhesive is an insulating material.

Step S603: Cure the protective adhesive to form a protective structure 360.

Step S604: Cover an insulating material on the mounting surface 110, and wrap a side surface and a top surface of each of an active component 121 and a passive component 122 with the insulating material, to form an insulating layer 310.

A side that is of the insulating layer 310 and that faces away from the mounting surface 110 forms a first surface 311. The first surface 311 undulatingly changes with different heights of the electronic components 120.

It may be understood that for step S601-step S604, refer to the description in step S501-step S504. Details are not described herein again.

Step S605: Remove a part of the insulating material from the top surface of the active component 121 to form a first trench 312 on the insulating layer 310, so that the first trench 312 is in communication with the top surface of the active component 121 to expose the top surface of the active component 121.

In this way, a side that is of the insulating layer 310 and that faces away from the mounting surface 110 forms a first surface 311 together with the top surface of the active component 121, and the first surface 311 undulatingly changes with different heights of the electronic components 120.

For example, if a size of the active component 121 is small in an x-axis direction, one or two first trenches 312 may be disposed on the insulating layer 310 corresponding to the top surface of the active component 121. If a size of the active component 121 is large in an x-axis direction, a plurality of, for example, three or four, first trenches 312 may be disposed on the insulating layer 310 corresponding to the top surface of the active component 121. In this way, the first trench 312 may be disposed as much as possible, provided that space for disposing the first trench 312 allows, thereby improving heat conduction efficiency, and further improving the heat dissipation effect on the active component 121.

Optionally, the first trench 312 may be formed through laser etching, plasma etching, or the like. A size of a side that is of the first trench 312 and that is close to the top surface of the active component 121 may be greater than or equal to 0.1 mm in the x-axis direction.

For example, the first trench 312 may be in a shape of a cylinder, a boss, a prism, or the like. This is not limited in this embodiment.

Step S606: Remove a part of the insulating material from a top surface of a ground pad 140 to form a second trench 313 on the insulating layer 310, so that the second trench 313 is in communication with the top surface of the ground pad 140 to expose the top surface of the ground pad 140.

It should be noted that for a formation manner of the second trench 313, refer to that of the first trench 312. Details are not described herein again.

It may be understood that step S606 and step S605 may be synchronously performed.

Step S607: Fill a thermal conductive material in the first trench 312 to form a thermal conductive structure 330, so that the thermal conductive structure 330 is connected to the top surface of the active component 121, and a side surface that is of the thermal conductive structure 330 and that faces away from the active component 121 is located on the first surface 311.

Optionally, the thermal conductive material may be a thermal conductive paste, metal particles, a thermal conductive gel, or the like. The thermal conductive paste may be a silver paste, an alloy thermal conductive paste, a graphene thermal conductive paste, or the like.

For example, if the thermal conductive material is a material that is in a liquid state in a high temperature state, for example, the thermal conductive paste or the thermal conductive gel, the material in the liquid state may be directly filled in the first trench 312 and then solidified, to form the thermal conductive structure 330. If the thermal conductive material is made of the metal particles or the like, the metal particles may be melted at a high temperature and filled or the metal particles are directly disposed in the first trench 312, to form the thermal conductive structure 330.

It should be noted that a shape of the thermal conductive structure 330 matches a shape of the first trench 312.

Step S608: Fill an electrical conductive material in the second trench 313 to form a first electrical conductive structure 370, so that one end of the first electrical conductive structure 370 is connected to the top surface of the ground pad 140, and the other end of the first electrical conductive structure 370 is located on the first surface 311.

It may be understood that step S608 and step S607 may be synchronously performed.

Step S609: Cover a shielding material on the first surface 311 to form a shielding layer 320, so that a shape of the shielding layer 320 matches a shape of the first surface 311, and the shielding layer 320 is electrically connected to a ground network of the printed circuit board 100.

Step S608 and step S607 may be omitted. In this way, the shielding material may be simultaneously filled in the first trench 312 and the second trench 313 in step S609, so that the shielding layer 320 can directly contact the top surface of the active component 121 and the top surface of the ground pad 140. For specific disposition of the shielding material in the first trench 312 and the second trench 313, refer to description in step S508. Details are not described herein again.

Step S610: Fill a thermal conductive gel 350 in a liquid state in at least a partial position on a side that is of the shielding layer 320 and that faces away from the first surface 311.

Step S611: Cure the thermal conductive gel 350.

Step S612: Cover graphite 204 on the shielding layer 320 and a side that is of the thermal conductive gel 350 and that faces away from the first surface 311 to form a graphite layer 340.

It may be understood that for step S608-step S612, refer to the description in step S507-step S511. Details are not described herein again.

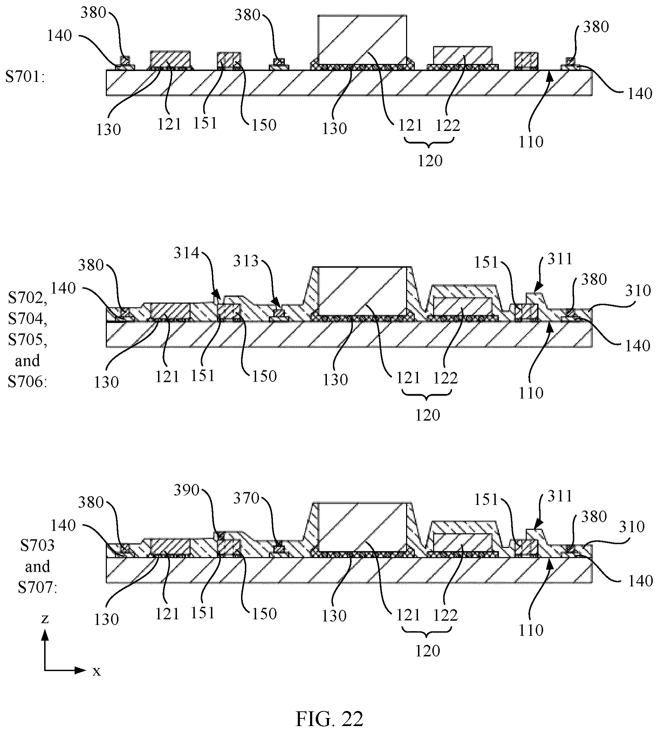

FIG. 22 shows a partial procedure of a diagram of a fourth procedure of processing a heat dissipation shielding structure on a printed circuit board according to an embodiment.

As shown in FIG. 22, the processing method of a heat dissipation shielding structure 300 provided in this embodiment may further include the following steps before steps S402, S504, and S604.

Step S701: Dispose an electrical conductive cushion block 380 on a ground pad 140.

In this way, a distance between the shielding layer 320 and the ground pad 140 can be shortened by using the electrical conductive cushion block 380, to prevent the second trench 313 from being excessively deep, thereby facilitating filling of the first electrical conductive structure 370 and grounding the shielding layer 320.

Optionally, the electrical conductive cushion block 380 may be a tin block, a copper block, a silver block, a carbon block, an electrical conductive adhesive block, or the like.

For example, the electrical conductive cushion block 380 may be connected to the ground pad 140 through welding. Alternatively, the electrical conductive cushion block 380 may be connected to the ground pad 140 by using an electrical conductive adhesive. This is not limited herein.

To facilitate electrical connection between the electrical conductive cushion block 380 and the shielding layer 320, in an implementation, before step S430, step S506, and step S606, the method may further include the following steps.

Step S702: Remove a part of the insulating material from a top surface of the electrical conductive cushion block 380 to form a second trench 313 on the insulating layer 310, so that the second trench 313 is in communication with the top surface of the electrical conductive cushion block 380 to expose the top surface of the electrical conductive cushion block 380.

It may be understood that for removal of the insulating material, refer to step S506. Details are not described herein again.

Step S703: Fill an electrical conductive material in the second trench 313 to form a first electrical conductive structure 370, so that one end of the first electrical conductive structure 370 is connected to the top surface of the electrical conductive cushion block 380 and the other end of the first electrical conductive structure 370 is located on the first surface 311.

In another implementation, before step S430, step S506, and step S606, the method may further include:
Step S704: Remove the insulating material from a top surface of the electrical conductive cushion block 380 to expose the top surface of the electrical conductive cushion block 380, so that the top surface of the electrical conductive cushion block 380 is located on the first surface 311.

It may be understood that any one of step S704 and step S702 may be selected according to an actual requirement. When there are a plurality of electrical conductive cushion blocks 380, both the two steps may be selected. This is not limited in this embodiment. When step S704 and step S702 are used simultaneously, step S704 and step S702 may be performed simultaneously. In addition, the two steps may be simultaneously performed with step S606 and step S605, and step S506 and step S505.

To facilitate grounding connection of the shielding layer 320 and the printed circuit board 100, the passive component 122 includes a capacitor 150, and the capacitor 150 has a ground terminal 151. In an implementation, before step S430, step S506, and step S606, the method may further include:

Step S705: Remove the insulating material from a top surface of the ground terminal 151 to expose the top surface of the ground terminal 151, so that the top surface of the ground terminal 151 is located on the first surface 311.

In another implementation, before step S430, step S506, and step S606, the method may further include the following steps.

Step S706: Remove a part of the insulating material from a top surface of the ground terminal 151 to form a third trench 314 on the insulating layer 310, so that the third trench 314 is in communication with the top surface of the ground terminal 151 to expose the top surface of the ground terminal 151.

It should be noted that for formation of the third trench 314, refer to formation of the first trench 312 and the second trench 313. Details are not described herein again.

Step S707: Fill an electrical conductive material in the third trench 314 to form a second electrical conductive structure 390, so that one end of the second electrical conductive structure 390 is connected to the top surface of the ground terminal 151 and the other end of the second electrical conductive structure 390 is located on the first surface 311.

It should be noted that for formation of the second electrical conductive structure 390, refer to formation of the first electrical conductive structure 370. Details are not described herein again.

It may be understood that step S705 or step S706 and step S707 may be selected according to an actual requirement. When there are a plurality of capacitors 150, Step S705, and step S706 and step S707 may be selected. This is not limited in this embodiment. When step S705, and step S706 and step S707 are used simultaneously, step S705 and step S706 may be performed simultaneously, and may be simultaneously performed with step S606 and step S605, and step S506 and step S505. In addition, step S707 may be simultaneously performed with step S507, step S608, and step S607.

According to a third aspect, an embodiment provides a circuit board assembly, including a printed circuit board 100 and the heat dissipation shielding structure 300 according to the first aspect. The printed circuit board 100 includes a mounting surface 110, electronic components 120 are mounted on the mounting surface 110, the electronic components 120 include an active component 121 and a passive component 122, and heat generation of the active component 121 is greater than heat generation of the passive component 122. Functional operations required by the printed circuit board 100 are implemented by using the active component 121 and the passive component 122. In addition, quantities and types of active components 121 and passive components 122 may be selected according to the functional requirements, and are not limited in this application.

An insulating layer 310 is covered on the mounting surface 110, the insulating layer 310 wraps a side surface and a top surface of the passive component 122, and the insulating layer 310 wraps at least a side surface of the active component 121. A shielding layer 320 is electrically connected to a ground network of the printed circuit board 100. The insulating layer 310 and the shielding layer 320 are disposed to shield the electronic components 120 and further improve a heat dissipation effect on the electronic components 120. In addition, contour-conforming coverage of the insulating layer 310 and the shielding layer 320 can reduce occupation of z-directional space, thereby reducing an overall size of the circuit board assembly, and implementing miniaturization design.

According to a fourth aspect, an embodiment provides an electronic device, including the circuit board assembly according to the third aspect. Because a heat dissipation effect of the circuit board assembly is good, difficulty of designing a heat dissipation system for the electronic device can be reduced. In addition, because the circuit board assembly occupies small space, miniaturization design of the electronic device can be implemented.

It should be noted that a person skilled in the art can easily figure out another implementation solution of this application after considering this specification and practicing this application that is disclosed herein. This application is intended to cover any variations, functions, or adaptive changes of this application. These variations, functions, or adaptive changes comply with general principles of this application, and include common knowledge or a commonly used technical means in the art that is not disclosed in this application. This specification and the embodiments are merely considered as examples, and the actual scope of this application is pointed out by the claims.

It should be understood that this application is not limited to the precise structures described above and shown in the accompanying drawings, and various modifications and changes may be made without departing from the scope thereof. The scope of this application is limited only by the appended claims.

## Claims

1. A heat dissipation shielding structure, used in a printed circuit board (100), wherein the printed circuit board (100) comprises a mounting surface (110), electronic components (120) are mounted on the mounting surface (110), the electronic components (120) comprise an active component (121) and a passive component (122), and heat generation of the active component (121) is greater than heat generation of the passive component (122); and
the heat dissipation shielding structure comprises:
an insulating layer (310), wherein the insulating layer (310) is covered on the mounting surface (110), wraps a side surface and a top surface of the passive component (122), and wraps at least a side surface of the active component (121), so that a side that is of the insulating layer (310) and that faces away from the mounting surface (110) forms a first surface (311) or a side that is of the insulating layer (310) and that faces away from the mounting surface (110) forms a first surface (311) together with a top surface of the active component (121), and the first surface (311) undulatingly changes with different heights of the electronic components (120); and
a shielding layer (320), wherein the shielding layer (320) is covered on the first surface (311), a shape of the shielding layer (320) matches a shape of the first surface (311), and the shielding layer (320) is electrically connected to a ground network of the printed circuit board (100).

2. The heat dissipation shielding structure according to claim 1, wherein
the insulating layer (310) wraps the side surface of the active component (121), so that the side that is of the insulating layer (310) and that faces away from the mounting surface (110) forms the first surface (311) together with the top surface of the active component (121); and
the shielding layer (320) is covered on the top surface of the active component (121).

3. The heat dissipation shielding structure according to claim 1, wherein
the insulating layer (310) wraps the side surface and the top surface of the active component (121), so that the side that is of the insulating layer (310) and that faces away from the mounting surface (110) forms the first surface (311);
a first trench (312) is disposed on the insulating layer (310), and the first trench (312) is located between the top surface of the active component (121) and the shielding layer (320), and enables the top surface of the active component (121) to be in communication with the shielding layer (320); and
a thermal conductive structure (330) is filled in the first trench (312), one end of the thermal conductive structure (330) is connected to the top surface of the active component (121), and the other end of the thermal conductive structure (330) is connected to the shielding layer (320).

4. The heat dissipation shielding structure according to any one of claims 1-3, further comprising:
a graphite layer (340), wherein the graphite layer (340) is covered on a side that is of the shielding layer (320) and that faces away from the first surface (311).

5. The heat dissipation shielding structure according to claim 4, wherein
a thermal conductive gel (350) is disposed between the shielding layer (320) and the graphite layer (340).

6. The heat dissipation shielding structure according to claim 5, wherein
the shielding layer (320) has a concave portion (321);
the concave portion (321) is close to an edge of the electronic component (120), and is recessed toward the insulating layer (310); and
the thermal conductive gel (350) is filled in at least the concave portion (321).

7. The heat dissipation shielding structure according to any one of claims 1-3, wherein
a ground pad (140) is mounted on the mounting surface (110); and
the shielding layer (320) is electrically connected to the ground pad (140).

8. The heat dissipation shielding structure according to claim 7, wherein
a second trench (313) is disposed on the insulating layer (310), and the second trench (313) is located between a top surface of the ground pad (140) and the shielding layer (320), and enables the top surface of the ground pad (140) to be in communication with the shielding layer (320);
the shielding layer (320) comprises a main body portion (322) and a first electrical conductive portion (323);
the main body portion (322) is covered on the first surface (311), and a shape of the main body portion (322) matches the shape of the first surface (311); and
the first electrical conductive portion (323) is filled in the second trench (313), one end of the first electrical conductive portion (323) is connected to the main body portion (322), and the other end of the first electrical conductive portion (323) is connected to the top surface of the ground pad (140).

9. The heat dissipation shielding structure according to claim 7, wherein
a second trench (313) is disposed on the insulating layer (310), and the second trench (313) is located between a top surface of the ground pad (140) and the shielding layer (320), and enables the top surface of the ground pad (140) to be in communication with the shielding layer (320); and
a first electrical conductive structure (370) is filled in the second trench (313), and the first electrical conductive structure (370) is electrically connected to the ground pad (140) and the shielding layer (320).

10. The heat dissipation shielding structure according to claim 9, wherein
one end of the first electrical conductive structure (370) is connected to the top surface of the ground pad (140), and the other end of the first electrical conductive structure (370) is connected to the shielding layer (320).

11. The heat dissipation shielding structure according to claim 9, further comprising: an electrical conductive cushion block (380), wherein the electrical conductive cushion block (380) is disposed on the top surface of the ground pad (140);
the insulating layer (310) wraps a side surface and a top surface of the electrical conductive cushion block (380);
the second trench (313) is located between the top surface of the electrical conductive cushion block (380) and the shielding layer (320), and enables the top surface of the electrical conductive cushion block (380) to be in communication with the shielding layer (320); and
one end of the first electrical conductive structure (370) is connected to the top surface of the electrical conductive cushion block (380), and the other end of the first electrical conductive structure (370) is connected to the shielding layer (320).

12. The heat dissipation shielding structure according to claim 7, further comprising:
an electrical conductive cushion block (380), wherein the electrical conductive cushion block (380) is disposed on a top surface of the ground pad (140);
the insulating layer (310) wraps a side surface of the electrical conductive cushion block (380);
a top surface of the electrical conductive cushion block (380) is located on the first surface (311); and
the shielding layer (320) is connected to the electrical conductive cushion block (380).

13. The heat dissipation shielding structure according to any one of claims 1-3, wherein
the passive component (122) comprises a capacitor (150), and the capacitor (150) has a ground terminal (151); and
the shielding layer (320) is electrically connected to the ground terminal (151).

14. The heat dissipation shielding structure according to claim 13, wherein
a third trench (314) is disposed on the insulating layer (310), and the third trench (314) is located between a top surface of the ground terminal (151) and the shielding layer (320), and enables the top surface of the ground terminal (151) to be in communication with the shielding layer (320);
the shielding layer (320) comprises a main body portion (322) and a second electrical conductive portion (324);
the main body portion (322) is covered on the first surface (311), and a shape of the main body portion (322) matches the shape of the first surface (311); and
the second electrical conductive portion (324) is filled in the third trench (314), one end of the second electrical conductive portion (324) is connected to the main body portion (322), and the other end of the second electrical conductive portion (324) is connected to the top surface of the ground terminal (151).

15. The heat dissipation shielding structure according to claim 13, wherein
a third trench (314) is disposed on the insulating layer (310), and the third trench (314) is located between a top surface of the ground terminal (151) and the shielding layer (320), and enables the top surface of the ground terminal (151) to be in communication with the shielding layer (320); and
a second electrical conductive structure (390) is filled in the third trench (314), one end of the second electrical conductive structure (390) is connected to the top surface of the ground terminal (151), and the other end of the second electrical conductive structure (390) is connected to the shielding layer (320).

16. The heat dissipation shielding structure according to any one of claims 1-3, wherein
the electronic component (120) is connected to the mounting surface (110) by using an electrical connection structure (130), and there is a gap between a bottom surface of the electronic component (120) and the mounting surface (110);
the heat dissipation shielding structure further comprises
a protective structure (360), and the protective structure (360) is filled in the gap between the bottom surface of the electronic component (120) and the mounting surface (110), and surrounds the electrical connection structure (130); and
a material of the protective structure (360) is an insulating material.

17. The heat dissipation shielding structure according to any one of claims 1-3, wherein
the active component (121) comprises a processor (1211) and a memory (1212) that are stacked;
the processor (1211) is connected to the mounting surface (110); and
the memory (1212) is electrically connected to the processor (1211).

18. A processing method of a heat dissipation shielding structure, comprising:
providing a printed circuit board, wherein the printed circuit board comprises a mounting surface, electronic components are mounted on the mounting surface, the electronic components comprise an active component and a passive component, and heat generation of the active component is greater than heat generation of the passive component;
covering an insulating material on the mounting surface, and wrapping a side surface and a top surface of the passive component and wrapping at least a side surface of the active component with the insulating material, to form an insulating layer, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components; and
covering a shielding material on the first surface to form a shielding layer, so that a shape of the shielding layer matches a shape of the first surface, and the shielding layer is electrically connected to a ground network of the printed circuit board.

19. The processing method of a heat dissipation shielding structure according to claim 18, wherein the covering an insulating material on the mounting surface, and wrapping a side surface and a top surface of the passive component and wrapping at least a side surface of the active component with the insulating material, to form an insulating layer, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components comprises:
covering the insulating material on the mounting surface, and wrapping the side surface and the top surface of each of the active component and the passive component with the insulating material; and
removing the insulating material from the top surface of the active component to expose the top surface of the active component to form the insulating layer, so that the side that is of the insulating layer and that faces away from the mounting surface forms the first surface together with the top surface of the active component, and the first surface undulatingly changes with the different heights of the electronic components.

20. The processing method of a heat dissipation shielding structure according to claim 18, wherein
the insulating material wraps the side surface and the top surface of the active component; and
after the covering an insulating material on the mounting surface, and wrapping a side surface and a top surface of the passive component and wrapping at least a side surface of the active component with the insulating material, to form an insulating layer, so that a side that is of the insulating layer and that faces away from the mounting surface forms a first surface or a side that is of the insulating layer and that faces away from the mounting surface forms a first surface together with a top surface of the active component, and the first surface undulatingly changes with different heights of the electronic components, the method further comprises:
removing a part of the insulating material from the top surface of the active component to form a first trench on the insulating layer, so that the first trench is in communication with the top surface of the active component to expose the top surface of the active component.

21. The processing method of a heat dissipation shielding structure according to claim 20, after the removing a part of the insulating material from the top surface of the active component to form a first trench on the insulating layer, so that the first trench is in communication with the top surface of the active component to expose the top surface of the active component, further comprising:
filling a thermal conductive material in the first trench to form a thermal conductive structure, so that the thermal conductive structure is connected to the top surface of the active component, and a side surface that is of the thermal conductive structure and that faces away from the active component is located on the first surface.

22. The processing method of a heat dissipation shielding structure according to any one of claims 18-21, after the covering a shielding material on the first surface to form a shielding layer, so that a shape of the shielding layer matches a shape of the first surface, and the shielding layer is electrically connected to a ground network of the printed circuit board, further comprising:
covering graphite on a side that is of the shielding layer and that faces away from the first surface to form a graphite layer.

23. The processing method of a heat dissipation shielding structure according to claim 22, before the covering graphite on a side that is of the shielding layer and that faces away from the first surface to form a graphite layer, further comprising:
filling a thermal conductive gel in a liquid state in at least a partial position on the side that is of the shielding layer and that faces away from the first surface; and
curing the thermal conductive gel.

24. The processing method of a heat dissipation shielding structure according to any one of claims 18-21, wherein a ground pad is mounted on the mounting surface; and
before the covering a shielding material on the first surface to form a shielding layer, so that a shape of the shielding layer matches a shape of the first surface, and the shielding layer is electrically connected to a ground network of the printed circuit board, the method further comprises:
removing a part of the insulating material from a top surface of the ground pad to form a second trench on the insulating layer, so that the second trench is in communication with the top surface of the ground pad to expose the top surface of the ground pad.

25. The processing method of a heat dissipation shielding structure according to claim 24, after the removing a part of the insulating material from a top surface of the ground pad to form a second trench on the insulating layer, so that the second trench is in communication with the top surface of the ground pad to expose the top surface of the ground pad, further comprising:
filling an electrical conductive material in the second trench to form a first electrical conductive structure, so that one end of the first electrical conductive structure is connected to the top surface of the ground pad and the other end of the first electrical conductive structure is located on the first surface.

26. The processing method of a heat dissipation shielding structure according to any one of claims 18-21, wherein a ground pad is mounted on the mounting surface; and
after the providing a printed circuit board, wherein the printed circuit board comprises a mounting surface, electronic components are mounted on the mounting surface, the electronic components comprise an active component and a passive component, and heat generation of the active component is greater than heat generation of the passive component, the method further comprises:
disposing an electrical conductive cushion block on the ground pad.

27. The processing method of a heat dissipation shielding structure according to claim 26, before the covering a shielding material on the first surface to form a shielding layer, so that a shape of the shielding layer matches a shape of the first surface, and the shielding layer is electrically connected to a ground network of the printed circuit board, further comprising:
removing the insulating material from a top surface of the electrical conductive cushion block to expose the top surface of the electrical conductive cushion block, so that the top surface of the electrical conductive cushion block is located on the first surface.

28. The processing method of a heat dissipation shielding structure according to claim 26, before the covering a shielding material on the first surface to form a shielding layer, so that a shape of the shielding layer matches a shape of the first surface, and the shielding layer is electrically connected to a ground network of the printed circuit board, further comprising:
removing a part of the insulating material from a top surface of the electrical conductive cushion block to form a second trench on the insulating layer, so that the second trench is in communication with the top surface of the electrical conductive cushion block to expose the top surface of the electrical conductive cushion block.

29. The processing method of a heat dissipation shielding structure according to claim 28, after the removing a part of the insulating material from a top surface of the electrical conductive cushion block to form a second trench on the insulating layer, so that the second trench is in communication with the top surface of the electrical conductive cushion block to expose the top surface of the electrical conductive cushion block, further comprising:
filling an electrical conductive material in the second trench to form a first electrical conductive structure, so that one end of the first electrical conductive structure is connected to the top surface of the electrical conductive cushion block and the other end of the first electrical conductive structure is located on the first surface.

30. The processing method of a heat dissipation shielding structure according to any one of claims 18-21, wherein
the passive component comprises a capacitor, and the capacitor has a ground terminal; and
before the covering a shielding material on the first surface to form a shielding layer, so that a shape of the shielding layer matches a shape of the first surface, and the shielding layer is electrically connected to a ground network of the printed circuit board, the method further comprises:
removing the insulating material from a top surface of the ground terminal to expose the top surface of the ground terminal, so that the top surface of the ground terminal is located on the first surface.

31. The processing method of a heat dissipation shielding structure according to any one of claims 18-21, wherein
the passive component comprises a capacitor, and the capacitor has a ground terminal; and
before the covering a shielding material on the first surface to form a shielding layer, so that a shape of the shielding layer matches a shape of the first surface, and the shielding layer is electrically connected to a ground network of the printed circuit board, the method further comprises:
removing a part of the insulating material from a top surface of the ground terminal to form a third trench on the insulating layer, so that the third trench is in communication with the top surface of the ground terminal to expose the top surface of the ground terminal.

32. The processing method of a heat dissipation shielding structure according to claim 31, after the removing a part of the insulating material from a top surface of the ground terminal to form a third trench on the insulating layer, so that the third trench is in communication with the top surface of the ground terminal to expose the top surface of the ground terminal, further comprising:
filling an electrical conductive material in the third trench to form a second electrical conductive structure, so that one end of the second electrical conductive structure is connected to the top surface of the ground terminal and the other end of the second electrical conductive structure is located on the first surface.

33. The processing method of a heat dissipation shielding structure according to any one of claims 18-21, after the providing a printed circuit board, wherein the printed circuit board comprises a mounting surface, electronic components are mounted on the mounting surface, the electronic components comprise an active component and a passive component, and heat generation of the active component is greater than heat generation of the passive component, further comprising:
filling a protective adhesive in a gap between a bottom surface of the electronic component and the mounting surface, so that the protective adhesive surrounds an electrical connection structure connecting the bottom surface of the electronic component and the mounting surface, wherein a material of the protective adhesive is an insulating material; and
curing the protective adhesive to form a protective structure.

34. A circuit board assembly, comprising a printed circuit board (100) and the heat dissipation shielding structure according to any one of claims 1-17, wherein
the printed circuit board (100) comprises a mounting surface (110), electronic components (120) are mounted on the mounting surface (110), the electronic components (120) comprise an active component (121) and a passive component (122), and heat generation of the active component (121) is greater than heat generation of the passive component (122);
an insulating layer (310) is covered on the mounting surface (110), the insulating layer (310) wraps a side surface and a top surface of the passive component (122), and the insulating layer (310) wraps at least a side surface of the active component (121); and
a shielding layer (320) is electrically connected to a ground network of the printed circuit board (100).

35. An electronic device, comprising the circuit board assembly according to claim 34.
